Europäisches Patentamt

European Patent Office

Office européen des brevets

(19)

(11) Publication number: **0 218 414**
**A2**

(12) **EUROPEAN PATENT APPLICATION**

(21) Application number: **86307339.1**

(22) Date of filing: **24.09.86**

(51) Int. Cl.⁴: **H 02 M 7/538**

(30) Priority: **30.09.85 US 781522**

(43) Date of publication of application:
**15.04.87 Bulletin 87/16**

(84) Designated Contracting States: **DE FR GB IT**

(71) Applicant: **MARATHON MANUFACTURING COMPANY**
**P.O. Box 61589**
**Houston Texas 77061 (US)**

(72) Inventor: **Masse, Michel Stephane**
**4401 Pampas Road**
**Woodland Hills California 91354 (US)**

**Colver, Franklin William**
**3976 Roanoke Lane**
**Costa Mesa California 92626 (US)**

(74) Representative: **Smith, Norman Ian et al**
**F.J. CLEVELAND & COMPANY 40-43 Chancery Lane**
**London WC2A 1JQ (GB)**

(54) Static inverter.

(57) A static inverter is disclosed which contains a circuit for synthesizing a periodic electrical waveform of a predetermined shape. The synthesized waveform appears at a capacitor which is periodically charged and discharged through several resistors. Some of the resistors are shorted out by this circuit at selected times during the charging and discharging cycles, so that the voltage appearing at the capacitor consists of a series of varying slopes; the slopes, corresponding to the RC time constants in the circuits, and the times at which the resistors are shorted out, determine the shape of the waveform. Control of the times at which the charging and discharging takes place, and at which the resistors are shorted out, may be accomplished by an oscillator circuit which provides a series of pulses of a fixed frequency to a counter, which in turn provides the required signals to the switches shorting out the resistor and to the switch which connects the RC circuit to either the charging or discharging voltage. Further disclosed is a circuit which controls the charging and discharging voltages, and thereby the output power of the static inverter, in response to a comparison of feedback signals proportional to the output current of the static inverter and to the output currents of parallel static inverters. Further disclosed is a temperature compensated oscillator circuit, consisting of a pair of NOR gates operating as logic inverters, with an RC network determining the frequency of oscillation. The temperature compensation of the oscillator is achieved by including a resistor in series with the power supply to the NOR gates which compensates for the temperature variation of the value of the capacitor, as the capacitor used has a positive temperature coefficient. Further disclosed is a circuit which boosts the DC voltage necessary for the portions of the static inverter which uses FETs as switches. This circuit consists of a comparator which compares a voltage proportional to the input DC voltage to a reference voltage. Upon the input DC voltage falling below a certain level, the comparator will close a switch (consisting of another FET) which connects the tap at the primary of a center tap transformer to the input DC voltage. A voltage will then be induced in the secondary of the center tap transformer, which has its tap connected to the input DC voltage, thereby boosting the voltage at the terminals of the secondary to a higher voltage. Further disclosed is a circuit which provides for "four-quadrant" operation of the static inverter by allowing the static inverter to absorb energy stored by a reactive load; such absorption is necessary so that the output waveform is not disturbed by the reactive load. This circuit consists of FETs connected between each output terminal and a common node, with logic controlling the gate voltage of the FETs so that the FETs are conductive for a brief period of time when the static inverter is not sourcing power, and so that a "hard" turn-off voltage is briefly applied to the gates of the FETs as the static inverter begins to source power again.

EP 0 218 414 A2

FIG. 1

**Description**

STATIC INVERTER

Background of the Invention

This invention relates to the field of modulated static inverters. A static inverter is an electrical circuit designed to provide an alternating current output from a direct current voltage input. The technique used in the static inverter of this invention, as well as many other static inverters, is pulse width modulation. Pulse width modulation refers to the technique by which a signal corresponding to the output of the static inverter is compared against a reference waveform. The output of the static inverter is then driven by a series of pulses, with the time duration, or width, of each pulse proportional to the difference between the output voltage and the amplitude of the reference waveform at a given point in time.

The shape of the reference waveform is important in pulse width modulation, as the output waveform of the static inverter will tend to approximate the shape of the reference waveform. Therefore, synthesis of the reference waveform in the static inverter is a critical step in its proper operation. Prior techniques for generating a reference waveform have used such techniques as resistordiode networks, where the diodes clamped the generated voltage at predetermined times, creating a waveform having a number of ramp sections followed by "flat" voltages for short periods of time, created by the clamping effect of the diodes. This technique therefore can synthesize an accurate representation of a sine wave, but only by using a large number of components. Furthermore, because the diodes have forward voltage drops which are temperature sensitive and because the small-signal nature of the waveform synthesis network makes the synthesized waveform highly responsive to the temperature variations of the diode forward voltage drops, such resistor-diode networks require the use of temperature compensation techniques. Other techniques using clamping diodes or other switching techniques created staircase style waveforms, also requiring a large number of components to synthesize an accurate waveform. In addition, if "smoothing out" of the synthesized waveforms is performed, such an operation will phase-shift the synthesized waveform relative to the clock pulses controlling the circuit. Therefore, an object of this invention is to provide a technique for synthesizing a sinusoidal-type waveform using relatively few components but which is accurate in its representation of the sine wave, without the "flat" or staircase voltages of the resistor diode network.

Another object of this invention is to provide a technique for synthesizing a sinusoidal-type waveform which has a shape which does not depend upon diode forward voltage drops and therefore which is relatively temperature insensitive.

Another object of the invention is to provide a technique for synthesizing a sinusoidal-type waveform which is not phase-shifted relative to the clock pulses controlling the synthesis circuit.

In addition, it is economical in the manufacture of static inverters if the static inverter can be converted to operate at different frequencies by changing a minimum number of components; conversion of the resistor-diode network to generate a different frequency reference waveform requires the careful selection of the values of several components.

Therefore, another object of this invention is to provide an economical waveform synthesis circuit, allowing a change from one frequency to another merely by the replacement of a minimal number of components, and without the need to carefully select component values.

Another object of this invention is to provide a method by which the reference waveform amplitude can be modulated to adjust for its share of the output load current relative to other static inverters connected in parallel with it.

The frequency of operation of the reference waveform and, accordingly, the output of a static inverter, is generally based upon a central oscillator circuit in the static inverter, which can be called the master oscillator circuit. This master oscillator circuit generally consists of two or more logic circuits acting as logic inverters (either inverters, NOR gates or NAND gates) in conjunction with an RC network. The logic inverters are connected together in such a way, as is well known in the art, so that they form an astable multivibrator. Contained within the circuit is an RC network which determines the frequency of oscillation of the multivibrator. Since a stable frequency of operation over temperature is desired, a problem exists if the capacitance of the capacitor in the RC network changes over temperature. A usual capacitor type used in such an oscillator is a mica capacitor, commonly having a positive temperature coefficient. If no compensation for this temperature coefficient is provided, as the ambient temperature of the static inverter increases, the capacitance of the capacitor in the multivibrator circuit will also increase, thereby slowing down the frequency of oscillation of the multivibrator. Prior compensation techniques have connected a capacitor with a negative temperature coefficient in parallel with the mica capacitor having a positive temperature coefficient; in this way, hopefully the temperature variation of one capacitor is compensated for by the opposite variation of the parallel capacitor. However, it has been found that use of such a capacitor require careful matching of component values.

Therefore, another object of this invention is to provide an accurate and economical technique for compensating for the temperature drift of the master oscillator internal to the static inverter.

In order to connect multiple static inverters in parallel or in a multiphase system, synchronization of the static inverters is necessary. In order for this synchronization to occur, a signal of some sort must be shared among the static inverters, and each static inverter must synchronize its operation to this shared signal. Various synchronization techniques have been used in static inverters, but a recurring problem exists where an intermittent fault of the synchronization signal occurs, appearing as an additional synchronization pulse. It would be preferable if the static inverter would ignore this unexpected pulse, instead of attempting to synchronize with respect to it as current static inverters will do. The inventor has found that by providing a window of time during which a proper synchronization signal is to appear, all other signals not appearing within the window will be ignored. Furthermore, it is desirable that the static inverter, if operating alone, would be capable of monitoring its own frequency; the inventor has found that this can be done by use of the same window technique. It would also be economical if the static inverter could be converted to operate at difference frequencies in the synchronization process with a minimum of changes. In addition, in the event of a short circuit of the synchronization signal to either the input DC voltage or to ground, it is preferable that the static inverter would at that point continue operation without interruption because of the short circuit.

Therefore, another object of this invention is to provide a synchronization circuit which will ignore "false" synchronization pulses, and which will continue operation in the event of a short circuit of the synchronization signal to a high DC level or to ground.

Another object of this invention is to provide a frequency monitor circuit by which the frequency of synchronization pulses, as well as the frequency of the static inverter itself, can be monitored within a predetermined bandwidth of frequencies, and where the static inverter can be disabled if the synchronization pulses or the static inverter itself fall out of this frequency bandwidth.

Another object of this invention is to provide a frequency monitor circuit which can be easily adjusted for different frequencies of operation, as well as different acceptable bandwidths of frequencies.

Prior static inverters used primarily bipolar transistors for their switching drive transistors. Metal oxide semiconductor field effect transistors (MOSFETs) would be preferred for these functions in the static inverter because of their high switching speed. However, the bias and drive voltage required for MOS transistors to ensure the greater speed, is higher than the bias and drive voltage required for the operation of bipolar transistors. If the DC input voltage to the static inverter falls from its desired level, it is likely that, if MOS transistors are used, the operation of the static inverter will not only have reduced power at the output, but will also have faults in its timing circuits, possibly causing the static inverter to cease operation and, in some cases, causing damage to the static inverter. Therefore, it is preferable in such cases where the DC input voltage begins to drop from its desired level, that the bias on the MOS transistors be maintained at a proper level.

Therefore, another object of this invention is to provide a way of boosting the DC input voltage to a portion of the static inverter, so that the bias and drive voltage of control logic and drive circuitry can be maintained at a high voltage even if the DC input voltage falls below the desired level.

Static inverters are useful to power loads which have impedances with large reactive components. Because reactive impedances store energy, in order for the static inverter to provide the desired AC waveform at its output, it is necessary for the static inverter to absorb this energy. Therefore, the static inverter must have an output circuit in a so-called "four quadrant" configuration, i.e., capable of absorbing the energy stored by reactive loads. It is therefore preferable if a circuit were contained in the static inverter which can safely absorb, into the output of the static inverter, energy stored by a load with a highly reactive impedance, during such times as the static inverter is not driving a pulse of power.

Therefore, another object of this invention is to provide means by which a load with a high reactive component of impedance can be driven by a static inverter using pulse width modulation techniques, and which safely absorbs energy sourced by the load during the off-pulses of the static inverter so that the static inverter can maintain the proper output waveform.

Summary of the Invention

The invention may be incorporated in an apparatus for generating the reference waveform which includes a series RC network, wherein a number of the resistors in the network have controllable switches across them, so that during both the charging the discharging cycles of the capacitor, the resistors may be selectively shorted out at predetermined times, enabling the voltage waveform across the capacitor to appear as a series of differing slopes relating to the differing RC time constants. The invention may then include means by which the charging and discharging voltages of the RC network are controlled based upon a comparison of the output of the static inverter to the outputs of static inverters connected in parallel with it.

With respect to temperature control of the master oscillator, the invention may be incorporated in an oscillator circuit which has a resistor connected between the power supply to the logic inverters and the logic inverters themselves.

With respect to the synchronization and frequency monitor circuits, the invention may be practiced by the combination of a circuit which can sense the presence of a synchronization pulse, a circuit which measures a predetermined time commencing with this pulse, and a circuit which measures a time window beginning with the end of the first time period within which, if a synchronization pulse occurs, the pulse is passed on to the master oscillator of the static inverter.

With respect to providing sufficient bias to the MOS transistors and integrated circuits, the invention may be incorporated in an apparatus which includes generating a reference voltage at a comparator which will compare this reference voltage to a voltage proportional to the DC input voltage, and which includes a center tap transformer which is connected to the comparator in such a way that the primary of the transformer conducts current only when the DC input voltage is too low, causing a voltage to be induced at the secondary of the transformer in addition to the DC input voltage, thereby boosting the DC input voltage to an acceptable level.

With respect to "four-quadrant" operation of the static inverter, the invention may be practiced by placing a controllable switch between each output terminal of the static inverter and a common node, with this switch controllable by circuitry which closes the switch for a period of time after the pulse width modulation circuitry has disabled the output drive, thereby allowing any energy stored by a reactive load to pass through the controllable switches to the common node and be absorbed.

Other objects and a fuller understanding of the invention may be had by referring to the following description and claims, taken in conjunction with the accompanying drawings.

Brief Description of the Drawings

Figure 1 is a block diagram of the preferred embodiment of the static inverter.

Figure 2 is a schematic diagram of the circuit which performs the pulse width modulation process.

Figure 2A is a schematic diagram of the circuit which, as a result of the pulse width modulation, drives the output of the static inverter.

Figure 3 is a schematic diagram of the circuit performing synthesis of the referenced waveform.

Figure 4 is a timing diagram showing the operation of the circuit illustrated in Figure 3.

Figure 5 is a schematic diagram showing the temperature compensation of the circuits in the master oscillator of the static inverter.

Figure 6 is a schematic diagram of the circuit which changes the amplitude of the reference waveform in response to the comparison of the output of the static inverter to the outputs of static inverters in parallel with it.

Figure 7 is a schematic diagram of the circuit which performs the synchronization and frequency monitor functions in the static inverter.

Figure 7A is a timing diagram illustrating the operation of the circuit illustrated in Figure 7.

Figure 7B is a schematic diagram of the circuit which provides the synchronization pulses to the circuit illustrated in Figure 7.

Figure 8 is a schematic diagram of the circuit in the static inverter which boosts the DC voltage to the control logic and drive circuitry.

Figure 9 is a schematic diagram of the circuit which controls the operation of the controllable switches across the output terminals of the static inverter, for "four-quadrant" operation.

Figure 9A is a timing diagram showing the operation of the circuit illustrated in Figure 9.

DESCRIPTION OF THE PREFERRED EMBODIMENT:

General Operation

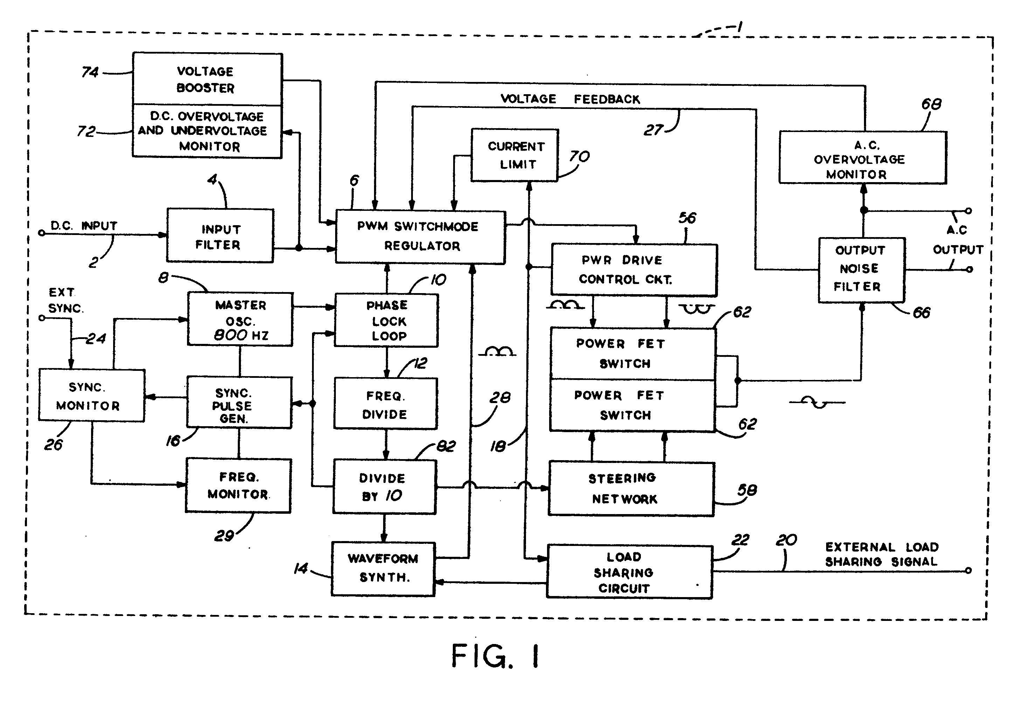

Figure 1 is a simplified block diagram of the preferred embodiment, illustrating static inverter 1 as made up of a number of circuit blocks which convert a DC power input into an AC output signal. The basic concept utilized in this embodiment to perform this process is pulse width modulation. Pulse width modulation is a method well known in the art by which the pulse widths of individual electrical pulses in a time series, at a frequency significantly greater than the fundamental frequency of the desired AC output, are modulated in such a fashion that, as the pulses are applied to output drive circuitry, the variation in the pulse widths produce the desired output signal. The modulation of the pulse widths is done by a reference waveform, such as a sinusoid, in combination with feedback signals from the output of static inverter 1, adjusting the reference waveform so that the desired output power of static inverter 1 is reached and controlled. Where the reference waveform is a full-wave rectified sinusoid, as in this case, proper pulse width modulation techniques allow a sinusoidal AC output with low distortion to be generated. While different control techniques can be used, this particular embodiment operates in the constant frequency current programmed mode, as is well known in the static inverter art, meaning that the pulse widths are modulated by a fixed value based on the peak output current of the power stages of the system.

Before discussing the general operation of static inverter 1, a description of a basic static inverter, as made up of necessary functional circuits, is useful. Referring to Figure 1, one of these basic circuits is master oscillator 8 which, when powered by a DC voltage, will produce a series of square wave pulses at a predetermined frequency. Waveform synthesizer 14 receives the modified output from master oscillator 8, and synthesizes the reference signal which will modulate the electrical pulses, as described above. Pulse width modulator ("PWM") switchmode regulator 6 is the primary structural circuit block for driving an AC output signal based on the DC power input. PWM switch mode regulator 6, based on voltage and current feedback from the output of static inverter 1, the sinusoidal reference generated by waveform synthesizer 14, and higher frequency digital pulses produced by a circuit such as phase lock loop 10 responsive to master oscillator 8, will have at its output a series of high frequency digital pulses, varying in pulse width according to a comparison between the feedback signals and the reference waveform, with the comparison occurring at the frequency of the high frequency digital pulses. This series of modulated pulses drive the output circuitry in such a way that an output corresponding to the reference waveform will be generated, capable of providing power to equipment at the load. As will be discussed below, a number of refinements to the basic structure of a static inverter are included in this embodiment, which enhance the operation of static inverter 1 over the basic static inverter described in this paragraph.

Looking now to the general operation of static inverter 1, by referring to Figure 1, DC input voltage 2 to static inverter 1 is filtered by low pass input filter 4 and is then connected to PWM switchmode regulator 6. Master oscillator 8 is set at twice the desired fundamental output frequency; in this embodiment this frequency is 800 Hz, since the desired fundamental output frequency of this embodiment is 400 Hz. The output of master oscillator 8 is a square wave, and is connected to the input of phase lock loop 10. Phase lock loop 10, as is well known in the art, generates an output which is phase-synchronous to the input signal and which is at a higher frequency which is an integral multiple of the input signal; in this embodiment this higher frequency is 120 kHz. The output of phase lock loop 10 is used as a 120 kHz clock to control logic circuitry in the remainder of static inverter 1. The 120 kHz square wave output from phase lock loop 10 is also connected to frequency divider 12. In this embodiment, frequency divider 12 provides an output at a frequency of 8 kHz which is phase synchronous with the 120 kHz signal. This 8 kHz signal is input to divide-by-ten 82 (also referred to herein as decade counter 82); one of the outputs of divide-by-ten 82 is an 800 Hz square wave, one-tenth the frequency of the 8 kHz input. The 800 Hz square wave output is used as an input to waveform synthesizer 14 as well as to synchronization pulse generator 16 and steering network 58. Waveform synthesizer 14, as will be described in greater detail below, generates reference waveform 28, which is in the form of a 400 Hz full waverectified sinusoidal signal. Reference waveform 28 is, as discussed above, a key input to PWM switch mode regulator 6. The amplitude of reference waveform 28 generated by waveform synthesizer 14 is controlled in part by a comparison of the output current of static inverter 1 with similar static inverters connected in parallel with it. Current feedback signal 18 is received from power drive control circuit 56, and is directly proportional to the output current of static inverter 1. Current feedback signal 18 is compared to external load share signal 20 in load sharing circuit 22, as will be described in further detail below. Based on the comparison of current feedback signal 18 to external load share signal 20, the amplitude of reference waveform 28 generated by waveform synthesizer 14 is appropriately controlled.

Besides being used to adjust the amplitude of reference waveform 28 in comparison with parallel static inverters, the AC output of static inverter 1 must also be synchronized and frequency controlled relative to other static inverters parallel with static inverter 1, or connected in a three-phase configuration. If external synchronization signal 24 is received from the other static inverters or other equipment in the environment, external synchronization signal 24, through synchronization monitor circuit 26 will control the synchronization of master oscillator 8. As will be described more fully below, synchronization monitor circuit 26 controls static inverter 1 in such a manner that if external synchronization signal 24 is present, but if master oscillator 8 is not synchronized to external synchronization signal 24, static inverter 1 will be kept in "standby mode," a nonoperational status. Furthermore, frequency monitor circuit 29 monitors pulses generated not only by external synchronization signal 24, but also by divide-by-ten 82 via synchronization pulse generator 16, so that the frequency of the output of static inverter 1 remains within a desired range, whether static inverter 1 is operating alone or in combination with other static inverters.

PWM switchmode regulator 6 is the primary circuit responsible for generating the desired AC output. 120 kHz clock signals from phase lock loop 10, reference waveform 28 generated by waveform synthesizer 14. voltage feedback signal 27 and current feedback signal 18 (via current limiter 70) serve as inputs to PWM switchmode regulator 6 and control the pulse width modulation process.

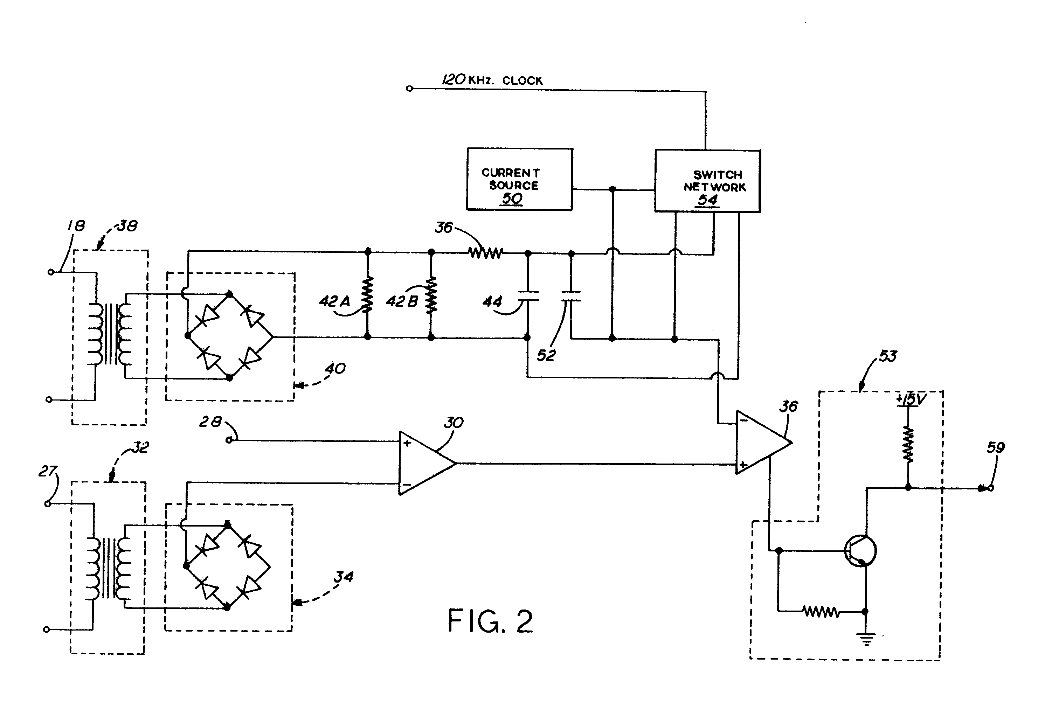

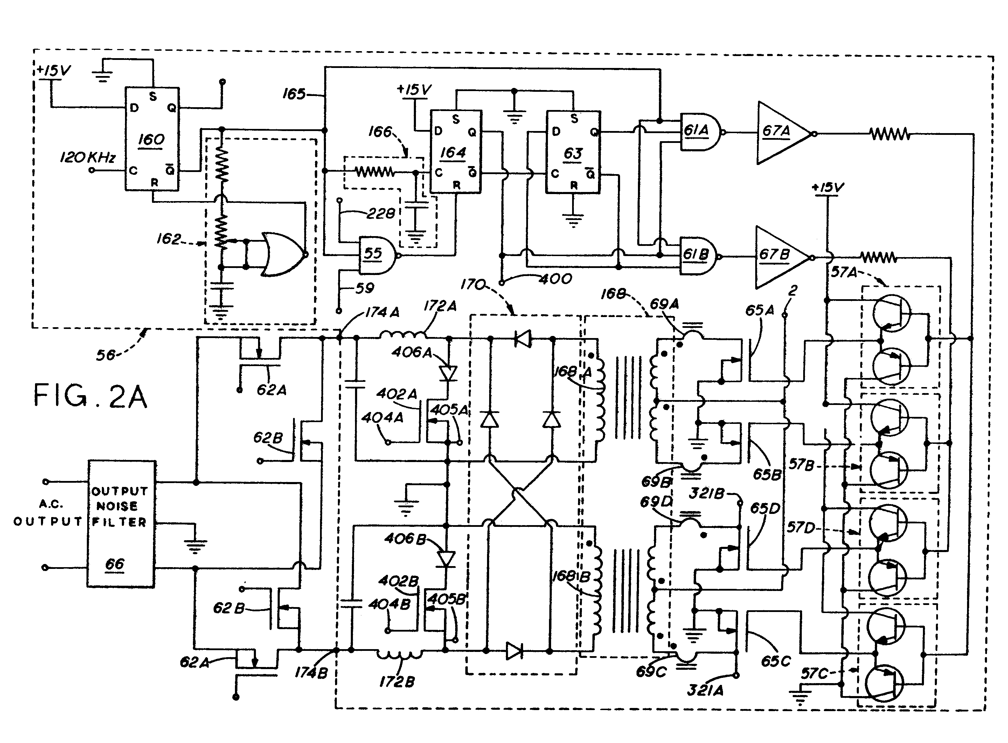

Figure 2 is a simplified schematic of PWM switchmode regulator 6. Reference waveform 28 is connected to the noninverting input of comparator 30. Voltage feedback signal 27 appears at the primary of transformer 32 in the form of a full sine wave. The induced signal appearing at the secondary of transformer 32 is full wave rectified by full wave rectifier 34, consisting of a diode bridge or other well known circuit, and the output of full wave rectifier 34 is then connected to the inverting input of comparator 30. Comparator 30 is a differential voltage comparator, as is well known in the art, and is biased in the usual manner. The output of comparator 30 is a voltage signal which is positive when the amplitude of the noninverting input is greater than the amplitude appearing at the inverting input. In such cases where the amplitude of the inverting input is greater than the amplitude of the noninverting input, comparator 30 is biased such that the output of comparator 30 is essentially at ground potential. In such cases where the amplitude of the noninverting input is greater than the amplitude of the inverting input of comparator 30, the output of comparator 30 is a voltage proportional to the difference between the two amplitudes. Therefore, when the amplitude of reference waveform 28 is greater than that of the voltage induced by voltage feedback signal 27 at the secondary of transformer 32, full-wave-rectified by full wave rectifier 34, comparator 30 will have a positive signal at its output. The positive signal will generally resemble, over time, a full-wave rectified 400 Hz sine wave. The output of comparator 30 is connected to the noninverting input of comparator 36 which, as discussed in detail below, controls power drive control circuit 56.

Current feedback signal 18 appears at the primary of transformer 38. The voltage induced by current feedback signal 18 at the secondary of transformer 38 is full wave rectified by full wave rectifier 40. This rectified signal is fed to precision resistors 42A and 42B across which a voltage which is directly and precisely proportional to the amplitude of current feedback signal 18, and therefore to the output of current of static inverter 1, is generated. This proportional signal then charges capacitor 44 through resistor 36 such that, as the output drive current and therefore the current feedback signal 18, increases, an increasing voltage, i.e.. a ramp, appears across capacitor 44. In order to eliminate potential instabilities inherent to static inverters in the current programmed mode at high duty cycles, the voltage ramp across capacitor 44 is added to a constant 120 kHz ramp generated by current source 50 charging capacitor 52. Switch network 54, controlled by the 120 kHz clock signal from phase lock loop 10, shorts out capacitors 44 and 52 at the frequency of 120 kHz, thereby creating a 120 kHz ramp (clipped sawtooth waveform) across capacitor 52. Thus the voltage which appears at capacitor 52, and which consequentially appears at the inverting input of comparator 36, is the sum of the voltage ramp proportional to current feedback signal 18 plus the fixed 120 kHz ramp generated by current source 50 and controlled by switch network 54. In effect, the signal appearing at the inverting input of comparator 36 is a modulated clipped sawtooth waveform with a fundamental frequency of 120 kHz.

The pulse width modulation is carried out by comparator 36 by its comparison of the output of comparator 30 and the modulated clipped sawtooth waveform across capacitor 52. The output of comparator 30, relating to the difference between reference waveform signal 28 and voltage feedback signal 27, is compared by comparator 36 to the voltage across capacitor 52. When the amplitude of the output of comparator 30 is greater than the voltage across capacitor 52, the emitter output of comparator 36 will have an output essentially at ground which, through inverter 53 will drive node 59 high and, as will be described below, will enable power drive control circuit 56, in turn enabling the output of static inverter 1. Therefore, at each point in time that the voltage at the output of static inverter 1 is less than the amplitude of reference waveform 28, and where the difference in said voltages is less than the amplitude of the voltage across capacitor 52, the output of static inverter 1 will be enabled. Whenever the output is enabled (i.e., when the output of comparator 30 is greater than the voltage across capacitor 52), the amplitude of current feedback signal 18 will rise in proportion to the current at the output of static inverter 1. In turn, via transformer 38, full wave rectifier 40 and precision resistors 42A and 42B, the voltage across capacitor 52 will rise proportionally until it equals the amplitude of the output of comparator 30, at which time the emitter output of comparator 36, and accordingly the voltage at node 59, will change state, causing power drive control circuit 56 to disable the output drive of static inverter 1. Therefore, when the amplitude of the output of comparator 30 is relatively low (e.g., when the amplitude of reference waveform 28 is low, near the "crossover" of the full-wave rectified sinusoid), power drive control circuit 56 will enable the output for only a short period of time; conversely, when the amplitude of the output of comparator 30 is relatively large (e.g., at the peak of the full-wave rectified sinusoids), power drive control circuit 56 will enable the output for a longer period of time. Therefore, PWM switchmode regulator 6 allows the load current to rise until the load voltage reaches its proper amplitude, corresponding to the amplitude of reference waveform signal 28. In this way, the pulse width modulation process has been accomplished to create a digital pulse string at node 59 which generates, through the variations in pulse width within each half cycle of reference waveform 28, an output signal which, when integrated as will be discussed below, will have essentially the shape of reference waveform 28 since the 120 kHz ramp frequency, and therefore the comparison frequency of comparator 36, is much greater than the frequency of reference waveform 28.

Referring again to Figure 1, the digital pulse string at node 59 appears at the output of PWM switchmode regulator 6 and is connected as an input to power drive control circuit 56.

Figure 2A is a schematic diagram of power drive control circuit 56 and its interface to power FET switches 62. The voltage at node 59, which is the output of inverter 53 connected to the emitter output of comparator 36 in PWM switchmode regulator 6, serves as one input to three input NAND gate 55. Another input to NAND gate 55 is "dead-time" signal 165, generated by R-S flip-flop 160 and reset circuit 162; "dead-time" signal 165 is at a low state for a very short period beginning at every pulse of the 120 kHz clock, which prevents both transistors of push-pull transistor pairs 57 A/B/C/D from conducting simultaneously. The third input to NAND gate 55 is disable signal 228, which is in a high state during operation. Therefore, when the output of inverter 53 is high, signifying an output enable condition, the output of NAND gate 55 and therefore the reset input of R-S flip-flop 164 is low. After the short period of time during which dead-time signal 165 is low, its low-to-high transition is delayed by R-C network 166 and toggles the clock input of R-S flip-flop 164. Since the reset input of R-S flip-flop 164 is held low by NAND gate 55, and since the "D" input of R-S flip-flop is tied to +15 volts, the "Q" output of R-S flip-flop 164 is set to a high state and the "Q̄" output goes low. Upon the next time that the output of NAND gate 55 goes high (i.e., when PWM switchmode regulator 6 disables power drive control circuit 56), R-S flip-flop 164 will reset, with the "Q" output going low and the "Q̄" output connected to the clock input of R-S flip-flop 63 going high, toggling R-S flip-flop 63. R-S flip-flop 63 has its "Q̄" output tied to its "D" input, so that upon each toggle of its clock input, the "Q" and "Q̄" outputs change state. Since the "Q" and "Q̄" outputs of R-S flip-flop 63 are necessarily complements, NAND gates 61A and 61B can never both have a low output at the same time; this prevents transistor pairs 57A and 57B (and accordingly transistor pairs 57C and 57D) from both having high outputs at the same time.

Therefore, the sequence of enabling transistor pairs 57A and 57B (and transistor pairs 57C and 57D in parallel) occurs in each pulse of the 120kHz clock as follows: (1) node 59 is low from PWM switchmode generator 6 from the prior cycle; (2) upon a 120kHz low-to-high pulse, dead-time signal 165 is briefly driven low, therefore node 59 goes high since no current output is sourced during the dead-time; (3) after dead-time signal 165 goes back high, R-S flip-flop 164 drives low the output of one of the NAND gates 61A or 61B (depending on which has the high output from R-S flip-flop 63), which will, in turn via inverters 67A and 67B, drive high, respectively, the outputs of transistor pairs 57 A/C or 57 B/D; and (4) as node 59 is subsequently driven low by the disable signal from PWM switchmode regulator 6, R-S flip-flop 164 is reset so that a low state is present at its "Q" output, driving the outputs of NAND gates 61A and 61B both high which pulls low the outputs of transistor pairs 57 A/B/C/D, and which toggles the "C" input of R-S flip-flop 63 so that whichever transistor pairs 57 A/C or 57 B/D were not enabled during this cycle will be enabled during the next cycle. Power drive control circuit 56 is then ready for the next 120 kHz cycle.

Still referring to Figure 2A, when any of transistor pairs 57 A/B/C/D have a high output, their respective FET driver 65 A/B/C/D will be driven into a conductive state, allowing current to pass from DC input voltage 2, boosted if necessary by voltage booster 74 shown in Figure 1 and discussed more fully below, through the primary of transformer 168, inducing a voltage at the secondaries 168 A/B of transformer 168. Note that since FET drivers 65A and 65C are on simultaneously, the voltage pulse induced at secondaries 168A and 168B are of the same polarity. Note also that in the next cycle, since FET drivers 65B and 65D, rather than FET drivers 65A and 65C, are conducting, the voltage pulses induced at secondaries 168A and 168B are of opposite polarity from the cycle before, and still of the same polarity as each other. Note that secondaries 168A and 168B are in effect connected in series. Therefore, the series of voltage pulses appearing at secondary 168A will be a series of pulses of alternating polarity and modulating width; the series of voltage pulses at secondary 168B also consists of a series of pulses of alternating polarity and modulating width, with each pulse of the same duration and the same polarity as the pulse appearing simultaneously at secondary 168A. This pair of series of alternating pulses are full-wave rectified by full-wave rectifier 170 and integrated by inductors 172A and 172B. Because PWM switchmode regulator has modulated the pulse widths in response to reference signal 28, at node 174A a full-wave rectified sine wave of positive polarity appears, and at node 174B a full-wave rectified sine wave of negative polarity appears. Nodes 174A and 174B correspond to the output of power drive control circuit 56 shown in Fig. 1. As an aside, transformers 69 A/B/C/D sense the currents driven by FET drivers 65 A/B/C/D respectively, for generating current feedback signal 18.

Referring back to Figure 1, steering network 58 is responsive to pulses generated from the 800 Hz square wave of divide-by-ten 82. The output of steering network 58 controls power FET switches 62 so that a full sine wave will appear at the output of static inverter 1. In effect, steering network 58 produces a high voltage at the gates of power FET switches 62A, shown on Figure 2A, during one cycle of the 800 Hz square wave, and produces a high voltage at the gates of power FET switches 62B, shown on Figure 2A, during the next cycle. In a manner discussed in more detail below, the 800 Hz square wave is differentiated and modified so that steering network 58 turns on the proper power FET switched pair 62A or 62B in the proper phase (rather than 180 degrees out of phase). By this means, steering network 58, via power FET switches 62A/B, "steers" the full-wave rectified sinusoids into output noise filter 66 as a 400 Hz full sine wave. Output noise filter 66 serves to remove radio-frequency interference from the output signal by conventional means.

With respect to the output monitoring of static inverter 1, referring to Figure 1, this embodiment contains AC overvoltage monitor circuit 68 which, via voltage feedback signal 27, will disable PWM switchmode regulator 6 so that static inverter 1 is put into a disabled state if any overvoltage condition is detected. Furthermore, based on feedback from power drive control circuit 56, current limit circuit 70 is used to override the function of comparator 30 if the current through power FET switches 62 is excessive.

This embodiment also contains a circuit by which the portion of DC input voltage 2 which is regulated for the logic circuitry and drive transistors (such as FET drivers 65 A/B/C/D of Figure 2A) is monitored, and boosted if necessary to the proper voltage. DC over-voltage and under voltage monitor 72, and voltage booster circuit 74 described in greater detail below, are designed to provide the required DC voltage to the control and drive circuits in the event that the external DC input voltage 2 falls below a specific level, and DC over-voltage and under-voltage monitor 72 is also designed to protect static inverter 1 from damage in the event of a DC over-voltage condition.

It should be apparent that the frequencies given in the preceding discussion and throughout this disclosure can be changed to different values merely by the changing of certain components. The choice of components to obtain a desired frequency different from those recited herein can be made using techniques and calculations well known to those skilled in the art.

Waveform Synthesis

For purposes of generally understanding the waveform synthesis technique used in this embodiment, waveform synthesizer 14 contains three basic circuit structures. One of these circuit structures is an RC charging circuit, by which a capacitor is charged and discharged through a series of discrete resistors; this structure also includes power sources which provide the voltage for charging and discharging the capacitor. The second major circuit structure is a number of switches, each connected in parallel to one of the discrete resistors, which can be selectively closed at predetermined times so that certain of the resistors in the charging and discharging circuit are shorted out. The third major circuit structure consists of timing means which control not only the times at which the charging and discharging circuit switches from a charging mode to a discharging mode, but also the specific times at which the switches are closed and opened. These three circuit structures cooperate to provide, at the capacitor being charged, a waveform made up of a series of RC time constants; the various RC time constants, chosen by the selection of the discrete resistor values, and the the times at which these resistors are shorted out of the charging and discharging circuit, determine the shape of the synthesized waveform.

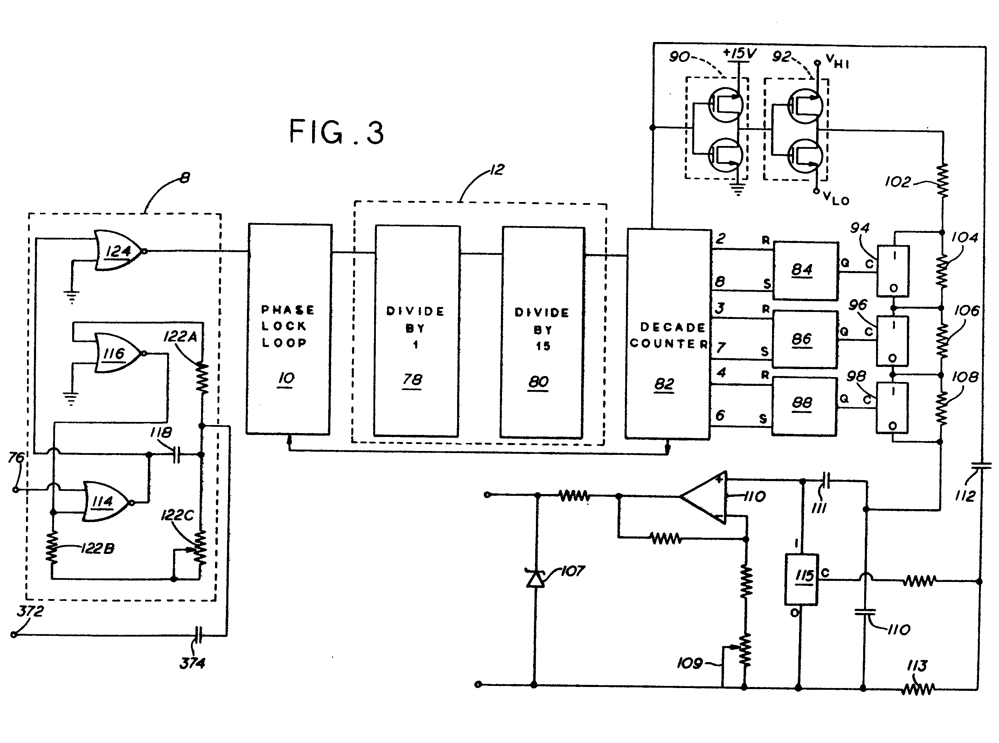

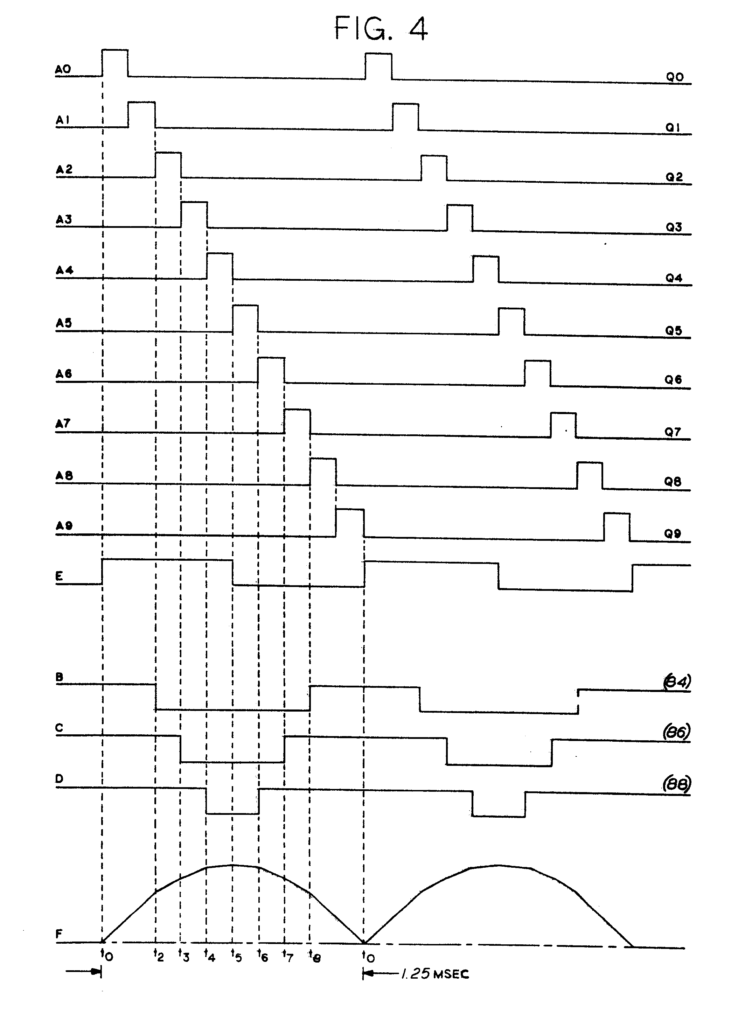

Figure 3 is a schematic diagram of waveform synthesizer 14 in this embodiment. Master oscillator 8 receives internal synchronization signal 76 and produces an 800 Hz square wave. This 800 Hz square wave is connected as an input to phase lock loop 10. Phase lock loop 10 is an integrated circuit, such as an RCA CD4046BF, which is biased as is well known in the art to produce a 120 kHz square wave at its output from the 800 Hz input signal. This 120 kHz signal is connected as an input to frequency divider 12, made up of two successive divide-by-n frequency dividers 78 and 80, which are biased and interconnected in this embodiment such that frequency divider 78 is a divide-by-one and frequency divider 80 is a divide-by-fifteen. Therefore, in this embodiment, the input to divide-by-ten (decade counter) 82 is an 8 kHz signal. Decade counter 82 is an integrated circuit. such as an RCA CD4017B, which has ten of its outputs corresponding to the digits zero through 9. As shown in waveforms A0 through A9 of Figure 4, decade counter 82 operates such that with each successive input pulse, the next successive output displays a pulse. Therefore in a given sequence of ten input pulses, the outputs representing the digits zero through 9 will toggle in a sequential manner. In addition, decade counter has an additional output corresponding to a carryout; this carryout signal is high when any of the outputs zero through 4 of decade counter 82 are high, and is low when any of the outputs 5 through 9 of decade counter 82 are high. Since the carryout signal repeats every ten input cycles, it is in effect a square wave at a frequency one-tenth of that of the input signal, hence giving decade counter 82 a divide-by-ten function. The outputs of decade counter 82 are connected to inputs of latches 84, 86 and 88 in a manner designed to properly synthesize the waveform. Latches 84, 86, and 88 are simple R-S latches, as are well known in the art, and operate in such a manner that when the "R" or "reset" input is toggled the output "Q" of said latch is low, and correspondingly when the "S" or "set" input of the latch is toggled, the output "Q" of said latch is high. In this embodiment, the "R" and "S" inputs of latch 84 are connected to the outputs of decade counter 82 such that the output corresponding to a "2" is connected to "R" input of latch 84, and the output of decade counter 82 corresponding to an "8" is connected to the "S" input of latch 84. Correspondingly for latch 86, the "R" input is connected to the output of the decade counter 82 corresponding to a "3," and the "S" input of latch 86 is connected to the output of decade counter 82 corresponding to a "7." Similarly, the "R" input of latch 88 is connected to the output of decade counter 82 which corresponds to a "4," and the "S" input of latch 88 is connected to the output of decade counter 82 which corresponds to a "6." Figure 4 shows the status of the outputs of latches 84, 86 and 88, over an arbitrarily chosen cycle of decade counter 82; again, in this embodiment, the units of time denoted as zero through 10 each correspond to 125 microseconds, since the input to the decade counter 82 is an 8 kHz signal. Waveform B corresponds to the output "Q" of latch 84, and shows that latch 84 is reset at t2, and set again at t8. Similarly, waveform C corresponds to the output "Q" of latch 86, and shows that the output "Q" of latch 86 is reset at t3, and set again at t7. Finally, waveform D corresponds to the output "Q" of latch 88, and shows that latch 88 is reset at t4, and set again at t6.

Waveform E represents the carryout output of decade counter 82. As explained above, this carryout output is high when any of outputs zero through 4 of decade counter 82 are high, and is low when any of outputs 5 through 9 of decade counter 82 are high. This carryout output of decade counter 82 is connected as an input to CMOS inverter 90. The output of CMOS inverter 90 is connected to the input of CMOS inverter 92. CMOS inverter 92 is biased, as will be explained later, so that when the p-channel transistor of CMOS inverter 92 is conducting, the output of CMOS inverter 92 is at $V_{hi}$; similarly, when the n-channel path of CMOS inverter 92 is conducting, the output of CMOS inverter 92 is at $V_{lo}$.

The outputs "Q" of latches 84, 86, and 88 control, respectively, switches 94, 96, and 98. These switches are CMOS bilateral switches as are well known in the art, such as RCA CD4066B switches. When the "C" input to said switches is high, the "I" input will be shorted to the "O" input; when the "C" input to the switch is low, an open circuit condition will exist between the "I" input and the "O". Referring to Figure 4 for an example, when the output of latch 84, represented by waveform B, is high, switch 94 will be in a closed condition, such that the I and O inputs of switch 94 are shorted together. Switches 94, 96 and 98, in conjunction with CMOS inverters 90 and 92, serve to charge capacitor 100 in a manner controlled by decade counter 82. In this embodiment, the voltage to which capacitor 100 is eventually charged will be a value significantly lower than $V_{hi}$. Referring again to Figure 4, switches 94, 96 and 98 are all closed at t0, since waveforms A, B, C and D are all in their high state. Since waveform E, representing the carryout output of decade counter 82, is in its high state, the output of CMOS inverter 92 is approximately $V_{hi}$. At this time, since the carryout signal from decade counter 82 has just made its low to high transition, CMOS inverter 92 will be charging capacitor 100 solely through resistor 102, since resistors 104, 106 and 108 are shorted out by switches 94, 96, and 98, respectively. This charging solely through resistor 102 is shown by waveform F of Figure 4. At t2, output of latch 84 goes low, because the reset input of latch 84 is toggled by the "2" output of decade counter 82, and therefore switch 94 opens. Therefore, beginning at t2, capacitor 100 is charged by CMOS inverter 92 through both resistor 102 and resistor 104. Accordingly, the slope of waveform F flattens, as is evident from the period of time beginning at t2. Subsequently, at t3, switch 96 similarly opens, allowing the charging of capacitor 100 to take place through resistors 102, 104, and 106. Finally, at t4. switch 3 is similarly opened, and the charging of capacitor 100 takes place through all four resistors, 102, 104, 106 and 108.

At t5, the carryout signal of decade counter 82 goes low. Therefore, the output of CMOS inverter 90 goes high and the output of CMOS inverter 92 goes to approximately $V_{lo}$. In this embodiment, $V_{lo}$ is significantly lower than the value to which capacitor 100 will be discharged. Therefore, capacitor 100 begins to discharge to the $V_{lo}$ terminal of CMOS inverter 92 through resistors 102, 104, 106 and 108. At t6, the "6" output of decade counter 82 is toggled, which sets latch 88, which in turn closes switch 98. Therefore, at t6, resistor 108 is no longer in the discharging circuit, and capacitor 100 discharges only through resistors 102, 104 and 106. Similarly, at t7, latch 86 is set, in turn switch 96 is closed, and the discharging of capacitor 100 is only through resistors 102 and 104. Finally, at t8, switch 94 is similarly closed, and the discharge of capacitor 100 is only through resistor 102. At t10, or t0 in the next cycle, the carryout signal of decade counter 82 goes high again, and the charging of capacitor 100 repeats.

By choice of the proper values for resistors 102, 104, 106 and 108, and through choice of the proper times at which the switching is to take place by choice of the outputs of decade counter 82, a half cycle of a sinusoid of a preselected frequency can be approximated. Note also that the synthesized waveform is phase-synchronous with the carry out signal of decade counter 82. In this embodiment, for a 400 Hz sinusoid, full-wave rectified, the value of resistor 102 is 19.1 kilo-ohms, the value of resistor 104 is 6.81 kilo-ohms, the value of resistor 106 is 13.3 kilo-ohms, and the value of resistor 108 is 63.4 kilo-ohms. Also, in this embodiment, the value of capacitor 100 is approximately .22 microfarads. It should be apparent here that reference waveform 28 could be generated at many different frequencies by the change of only a few components. First of all, merely by connecting frequency dividers 78 and 80 differently, or at most by replacing them with different frequency dividers, a signal of a frequency different from 8 kHz, but which is still a factor of 120 kHz could be generated at the input to decade counter 82. Once this is done, the value of capacitor 100 would have to be chosen accordingly; however, the change to a different frequency of reference waveform 28 can be accomplished by replacement of only these three components.

The slopes in waveform F are substantially linear, since the time constant of the RC charging circuit is significantly longer than the time from t0 to t5 (or from t5 to t10). As a result, a synthesized approximation of a full wave rectified sinusoidal wave with a frequency of 800 Hz, made up of linear portions with differing slopes, is presented to amplifier 110; capacitor 111 capacitively couples the synthesized waveform to amplifier 110 in order to remove the quiescent DC level of the waveform being amplified. After amplification by amplifier 110, this synthesized waveform becomes reference waveform 28 for static inverter 1.

The amplification process is enhanced by switch 115 which removes any residual DC voltage at the input to amplifier 110 at the end of every half-cycle. The carryout output of decade counter 82 is differentiated by capacitor 112 and resistor 113, and is presented at the clock input of switch 115, a CMOS bilateral switch such as switches 94, 96 and 98. At each low-to-high transition of the carryout output of decade counter 82, because of the differentiation a short positive pulse will appear at the clock input to switch 115, and capacitors 111 and 100 will be discharged through the short circuit of switch 115. This process, since it occurs at the time the carryout output of decade counter 82 makes its low-to-high transition (i.e., t0), occurs at the time that the voltage at capacitor 100 should be at its lowest point, i.e., the "crossover" point of the full-wave rectified sinusoid. This process of "refreshing" capacitors 111 and 100 removes any DC voltage which will build up at capacitors 111 and 100.

Potentiometer 109 allows the operator of static inverter 1 to preset the nominal amplitude of the output voltage of static inverter to the desired level by adjusting the gain of amplifier 110 by adjusting the voltage divider at its inverting (feedback) input. Zener diode 107 limits the maximum voltage of reference waveform 28 appearing at the output of amplifier 110 to a level which will prevent the damage to static inverter 1 which would occur if PWM switchmode regulator 6 enabled power drive control circuit 56 to attempt to reach an excessively high reference voltage.

Temperature Compensation of Master Oscillator

Master oscillator 8, as controlled by internal synchronization signal 76, and through phase lock loop 10 and dividers 78 and 80, generates a square wave which controls the frequency of the synthesized waveform and the frequency of operation of static inverter 1. Referring to Figure 3, master oscillator 8 primarily consists of NOR gates 114 and 116, capacitor 118 and resistors 122. NOR gate 124 is in this case merely acting as an inverter/buffer. During operation of the oscillator, internal synchronization signal 76 will not affect the circuit, except during such time as static inverter 1 is being synchronized. Capacitor 118 in this embodiment is of the value of 10,000 picofarads, resistor 122A is 165 kilo-ohms, resistor 122B is 53.2 kilo-ohms, and resistor 122C is a 20 kilo-ohm potentiometer. Capacitor 118 controls the frequency of master oscillator 8, as it controls the time delay between the output of NOR gate 116 appearing at the nongrounded input of NOR gate 116. As the capacitance value of capacitor 118 increases, the frequency of master oscillator 8 will decrease.

This inverse relationship of the frequency of master oscillator 8 with the value of capacitor 118 can be seen by walking through one of the cycles of the oscillator. For example, assuming that a "zero" is at the nongrounded input of NOR gate 116, a "one" will appear at the output of NOR gate 116. This "one" will then appear at the input of NOR gate 114, which will produce a zero at the output of NOR gate 114, as internal synchronization signal 76 is low during this time (assuming the oscillator is synchronized). Therefore, the output of NOR gate 116 will attempt to charge capacitor 118 through resistors 122B and 122C. The nongrounded input of NOR gate 116 will remain low until the output of NOR gate 116 charges capacitor 118, through resistors 122B and 122C, to a "one" value. Once capacitor 118 is charged to a "one" value, then NOR gate 116 will seen a "one" at its nongrounded input, and will drive a "zero" level at its output. This "zero" level will then appear again at the input to NOR gate 114, switching the output of NOR gate 114 to a "one" level, and will discharge capacitor 118 through resistors 122B and 122C to a level constituting a "zero" level at the input to NOR gate 116, starting the cycle over. Therefore, the oscillation time of master oscillator 8, and therefore its frequency, depends upon the time constant created by the product of the value of capacitor 118 with the sum of the resistances 122B and 122C. Note that potentiometer 122C allows external tuning of this frequency.

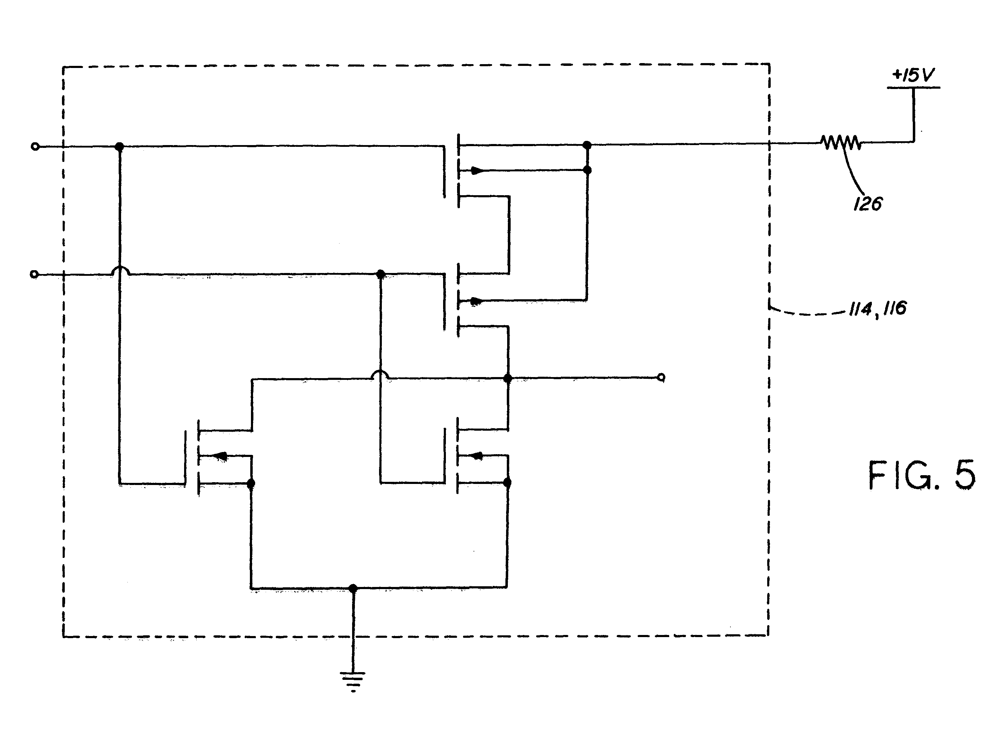

However, if the value of capacitor 118 drifts with temperature this time constant will also drift, and therefore the frequency of master oscillator 8 will similarly drift. Prior techniques have relied solely upon the use of a capacitor in parallel with capacitor 118 to compensate for the temperature drift of capacitor 118. In this embodiment, since 118 is a mica capacitor with a positive temperature coefficient (i.e., the capacitance value of capacitor 118 increases with temperature), the parallel capacitor has usually been chosen with a negative temperature coefficient such that the sum of the capacitances in parallel will remain relatively constant over temperature. However, using a parallel capacitor to compensate for the temperature variation requires careful matching of the component values to provide the necessary temperature compensation. Referring now to Figure 5, which illustrates the biasing technique and the internal schematic of one of the NOR gates 114 or 116 used in this embodiment, resistor 126 is included in series with the power supply to NOR gates 114 and 116. Resistor 126 can be chosen so that a very close compensation can be obtained depending upon the value and type of capacitor 118. In this embodiment, resistor 126 is a carbon composition resistor with a value of 120 ohms. By including this resistor in series with the power supply to NOR gates 114 and 116 in master oscillator 8, the temperature drift of capacitor 118 is fully compensated by the effect of resistor 126 on the characteristics of NOR gates 114 and 116, providing a stable frequency of oscillation for master oscillator 8 over temperature.

Load Sharing

Load sharing is accomplished in this embodiment by means of a circuit, shown as load sharing circuit 22 in Figure 1, which compares the output current of static inverter 1 to the output current of a static inverter or static inverters connected in parallel with static inverter 1, and which modulates reference waveform 28 accordingly.

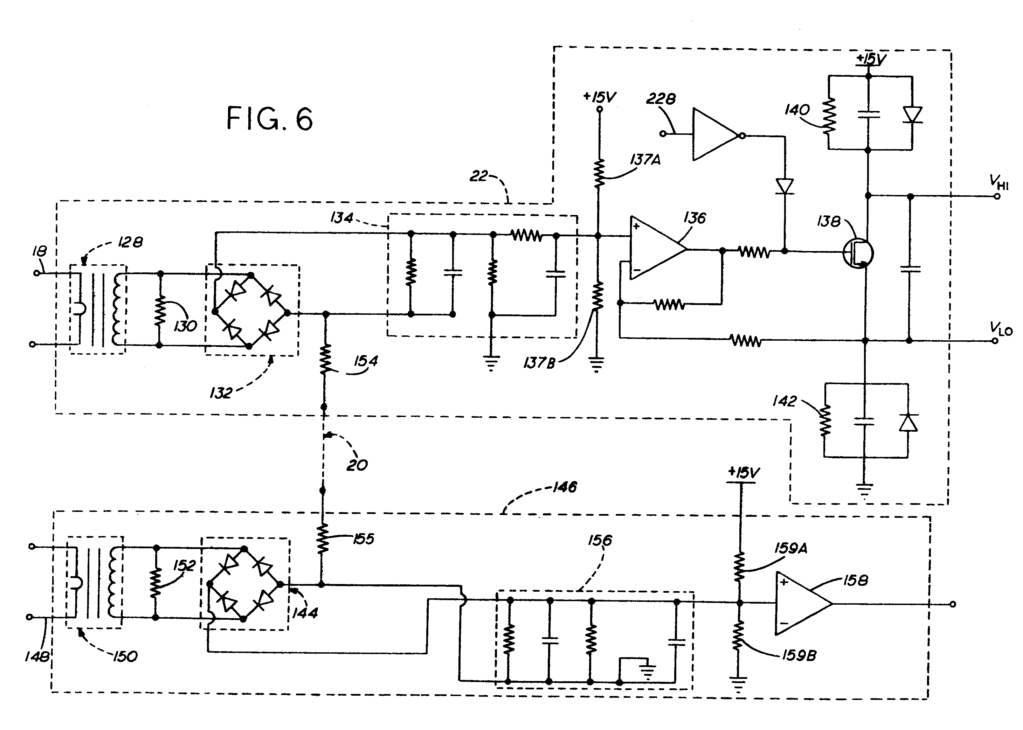

Figure 6 is a schematic diagram of load sharing circuit 22, illustrating the means by which $V_{hi}$ and $V_{lo}$, referred to in Figure 3 as the voltages controlling the amplitude to the reference waveform, are controlled.

Current feedback signal 18 passes through the primary of transformer 128 of Figure 6, inducing a voltage at the secondary of transformer 128 across resistor 130. This voltage is rectified by full wave rectifier 132, and is filtered by means of RC filter 134 such that the output of RC filter 134 is a DC value corresponding to the peak voltage of the full wave rectified voltage seen across resistor 130. This voltage is directly proportional to current feedback signal 18, which in turn is directly proportional to the current output of static inverter 1. This filtered voltage is presented at the noninverting input of amplifier 136, as is a voltage determined by the voltage divider of resistor 137A and 137B. However, if no static inverter is connected in parallel with static inverter 1, thus providing no external load sharing signal 20, the negative side of full wave rectifier 132 is floating, and the voltage at the non-inverting input to amplifier 136 is determined solely by the voltage divider of resistors 137A and 137B. The output of amplifier 136 is connected to the gate of n-channel enhancement FET 138. Therefore, the voltage at the non-inverting input of amplifier 136 controls the conduction of n-channel enhancement FET 138; for example, if this voltage increases, the gate of n-channel enhancement FET 138 is turned on further, allowing n-channel enhancement FET 138 to conduct more heavily. As n-channel enhancement FET 138 conducts more heavily, the voltage drops across resistors 140 and 142 increase, and the drain-to-source voltage of n-channel enhancement FET 138 is reduced. Since $V_{hi}$ is the drain voltage of n-channel enhancement FET 138, and since $V_{lo}$ is the source voltage of n-channel enhancement FET 138, in this example, the amplitude of the reference waveform is reduced as the output of amplifier 136 increases. Again, however, if no static inverter is connected in parallel to static inverter 1, the negative side of full wave rectifier 132 will float, and the input voltage to amplifier 136 is determined solely by the voltage divider.

The load sharing feature is accomplished by connection of the negative side of full wave rectifier 132 of static inverter 1 to the negative side of a full wave rectifier of a static inverter connected in parallel to static inverter 1, which provides external load share signal 20. Figure 6 shows full wave rectifier 144 in parallel static inverter 146. Similarly as current feedback signal 18 is sensed by transformer 128 and a voltage is induced across resistor 130, current feedback signal 148 of parallel static inverter 146 enters transformer 150 and a voltage is induced across resistor 152, which is rectified by full wave rectifier 144. Identically to static inverter 1, static inverter 146 connects the positive side of full wave rectifier 144 to filter 156, and to the non-inverting input of amplifier 158 in conjunction with the voltage divider of resistor 159A and 159B. In the event that the output current of parallel static inverter 146 increases relative to the output current of static inverter 1, the negative side of full wave rectifier 144 in static inverter 146 will be relatively more negative than the negative side of full wave rectifier 132 in static inverter 1. Therefore, the negative side of full wave rectifier 144 in static parallel inverter 146, serving as external load sharing signal 20 to static inverter 1, will pull down the voltage appearing at the input of amplifier 136 in static inverter 1 through resistors 154 and 155. This voltage is pulled down in this case because non-inverting input of amplifier 136 is now connected, through resistors in filter 134 and through resistors 154 and 155, to the negative side of full wave rectifier 144. In this case, where static inverter 146 is connected in parallel with static inverter 1 and is producing a higher output current, the voltage presented by filter 134 to the non-inverting input of amplifier 136 will be lower than that of the voltage divider of resistors 137A and 137B. When this occurs, the output of amplifier 136 will be reduced and, accordingly, n-channel enhancement FET 138 will become less conductive. As n-channel enhancement FET 138 conducts less, the voltage drop across resistors 140 and 142 will decrease, and as a result, $V_{hi}$ will modulate closer to the 15 volt power supply and $V_{lo}$ will modulate closer to ground potential. As $V_{hi}$ increases, referring back to Figure 3, the amplitude of the reference waveform of static inverter 1 will be accordingly increased and the output drive of static inverter 1 will be increased to more fully match the output of parallel static inverter 146. It should be apparent that as the output of static inverter 1 thereby increases relative to parallel static inverter 144, the negative side of full wave rectifier 132 will become more negative than the negative side of full wave rectifier 144 in static inverter 146, causing, in similar fashion, the output current of static inverter 146 to increase to match the output current of static inverter 1. In addition, as the output current of static inverter 1 increases, the positive side of full wave rectifier 132 will become more positive, causing the voltage at the non-inverting input of amplifier 136 to increase, thereby causing n-channel enhancement FET 138 to become more conductive and reducing the amplitude of reference waveform 28 (and the output current) by reducing $V_{hi}$ and increasing $V_{lo}$ as described above. As this process continues over time, the output current of the two parallel static inverters will tend to be equalized.

It should also be apparent that the described configuration will perform the load-sharing process where more than two static inverters are connected in parallel.

Synchronization and Synchronization Monitor Circuitry

The theory of operation of synchronization monitor circuit 26 is based on the fact that the desired synchronization pulses will appear at a relatively constant frequency; the purpose of synchronization monitor circuit 26 is therefore to allow synchronization of master oscillator 8 and to enable operation of static inverter 1 when the synchronization pulses are of the proper frequency, and to disable static inverter 1 and wait for proper synchronization pulses when the pulses are not of the proper frequency. The heart of synchronization monitor circuit 26 is counter 206, which provides a "window" of a predetermined time at a predetermined frequency. If synchronization pulses occur during the "window", synchronization monitor circuit 26 will enable static inverter 1; if the synchronization pulses do not occur during these "windows", synchronization monitor circuit 26 will disable static inverter 1 and will wait until two successive pulses of the proper frequency occur, at which time it will allow synchronization of master oscillator 8 and will enable static inverter 1. The width of the "window" determines the range of frequencies considered "proper". Synchronization monitor circuit 26 also is responsive to internally generated pulses, so that the frequency of operation of static inverter 1, if operating along, is monitored by synchronization monitor circuit 26. Note that the decision made by synchronization monitor circuit 26 is only whether or not a pulse appears during the proper time window; therefore, if a pulse occurs outside of this window, such as if an intermittent fault occurs, this fault will be ignored by synchronization monitor circuit 26 unless it impacts a pulse expected during the time window.

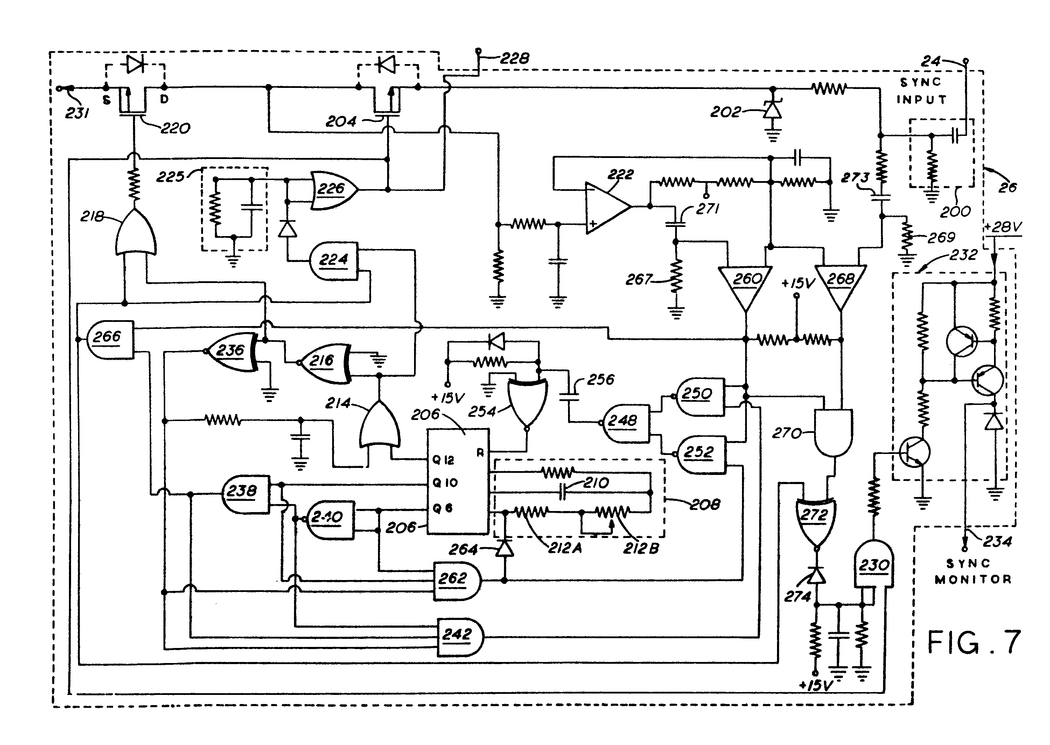

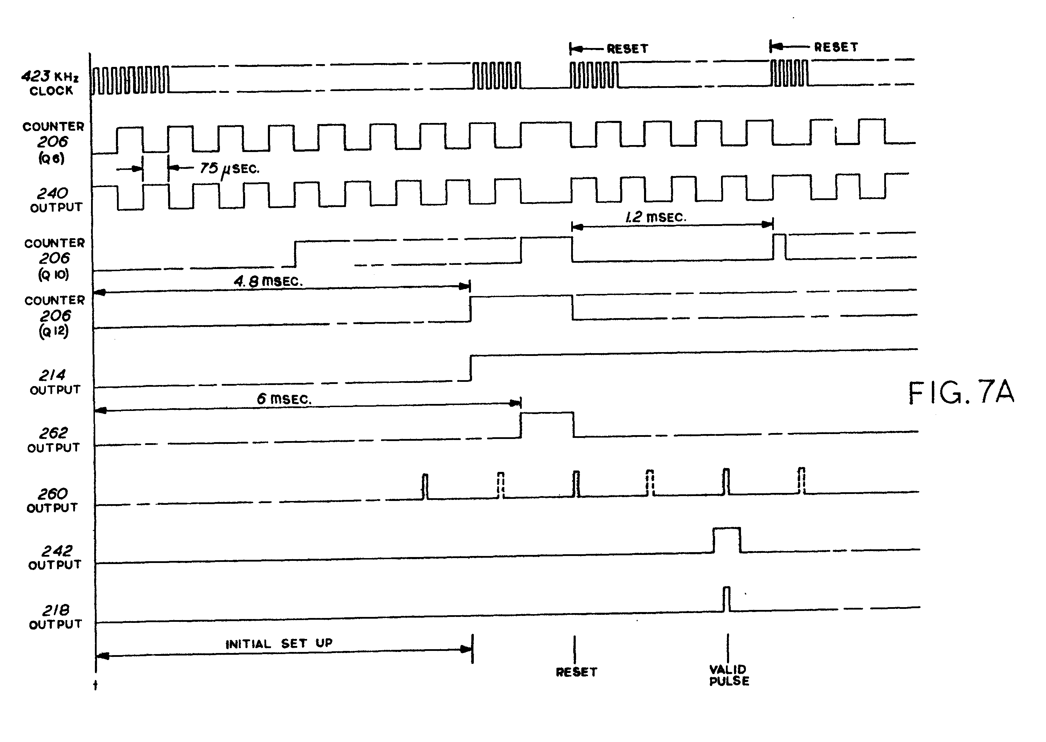

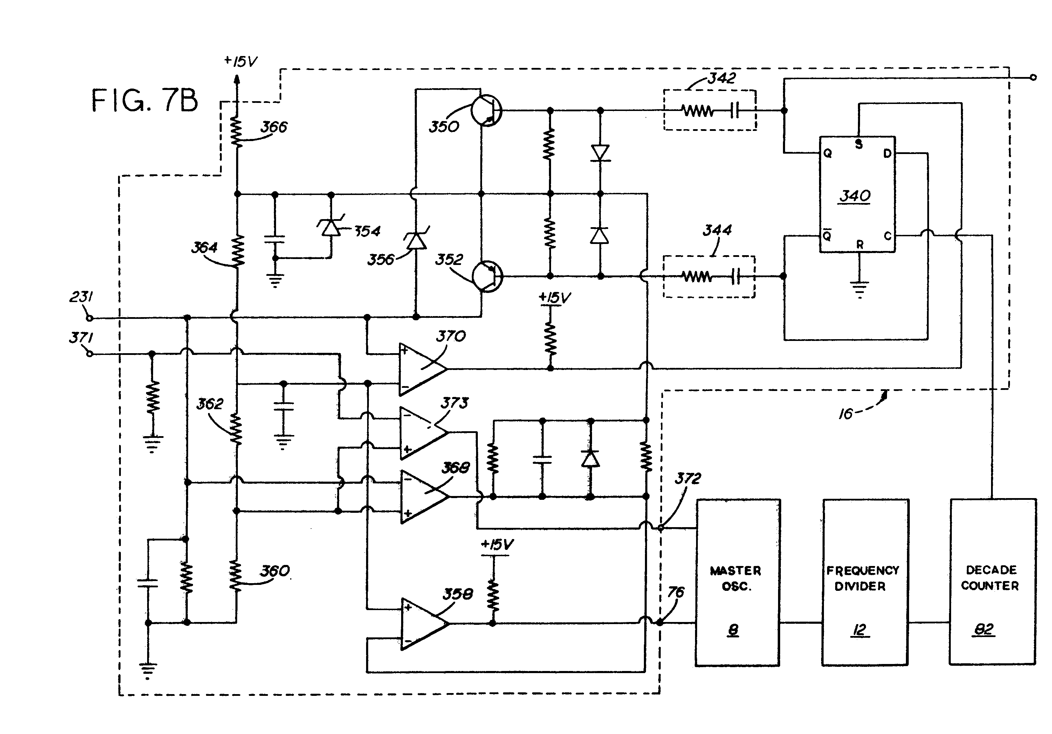

Figure 7 is a schematic diagram of synchronization monitor circuit 26. As stated earlier, a purpose of this circuit is to allow synchronization of static inverter 1 with either a parallel static inverter or some other synchronization signal external to static inverter 1. External synchronization signal 24 consisting of a series of pulses at a frequency of 800 Hz, and which will be described more fully below, is input into RC network 200, which serves to block any high DC signal from disturbing the operation of synchronization monitor circuit 26; because of the effect of RC network 200, a DC voltage at external synchronization signal 24, such as a fault causing a short to high DC voltage or to ground, will be blocked from affecting the operation of static inverter 1. Zener diode 202 prevents pulses of excessive voltage from appearing at the source of n-channel FET 204.

At power up of static inverter 1, all outputs of counter 206 are in their low state. Counter 206, in this embodiment, is a CMOS 14 stage ripple-carry binary counter/divider as is well known in the art, such as the RCA CD4060B. Counter 206 has outputs numbered Q4 through Q10 and Q12 through Q14, corresponding to $2^3$ through $2^9$ counts and $2^{11}$ through $2^{13}$ counts, respectively. Counter 206 is clocked by an internal oscillator controlled by RC network 208. The frequency of oscillation of counter 206 is dependent on the time constant created by capacitor 210 and resistors 212A and 212B, where resistor 212B consists of a potentiometer useful in tuning the frequency of oscillation. In this embodiment, the oscillation frequency of counter 206 is 423 kHz, with each cycle (and count of counter 206) having a 2.36 microsecond period. As counter 206 is powered up, each pulse of the internal oscillator of counter 206 (controlled by RC network 208) will enable one binary count of counter 206 in an upward direction. From power up until $2^{11}$ counts (approximately 4.8 msec) later, output Q12 of counter 206 remains low. Therefore, the output of OR gate 214 is in a low state and, in turn, the output of exclusive NOR gate 216 is in a high state. Since the output of exclusive NOR gate 216 is in a high state, the output of OR gate 218 is in a high state, which in turn turns on n-channel FET 220. Therefore, during the first 4.8 milliseconds after power up, pulses of external synchronization signal 24 will pass through the body diode of n-channel FET 204, through conducting n-channel transistor 220, and will appear at node 231, thereby becoming, as will be discussed in detail below, internal synchronization signal 76 and triggering master oscillator 8 of static inverter 1 (shown in Figure 3). Meanwhile, since the output of OR gate 214 is also low, the output of AND gate 224 is low, in turn making the output of OR gate 226 low, and disable signal 228 low, which keeps static inverter 1 in a standby condition. Referring back to Figure 6, when disable signal 228 is low, the voltage at the gate of n-channel enhancement FET 138 is high, forcing n-channel enhancement FET 138 into a fully conductive state and forcing $V_{hi}$ and $V_{lo}$ to the same potential, thereby preventing synthesis of reference waveform 28, which in effect disables static inverter 1. In addition, since the output of OR gate 226 is low, the output of AND gate 230 is low driving, through circuitry 232, synchronization monitor signal 234 to a low state, which in turn can indicate, through an indicator light or other means, to the operator of static inverter 1 that synchronization is not present.

When output Q12 of counter 206 goes to a high state, at $2^{11}$ counts (in this embodiment at 4.8 milliseconds), the output of OR gate 214 goes to a high state, in turn driving the output of exclusive NOR gate 216 to a low state. Exclusive NOR gate 236, which has a high output when the output of exclusive NOR gate 216 is low, latches OR gate 214 so that its output will remain at a high state from this point on. Also at this time, since the output of exclusive NOR gate 216 is now at a low state, the output of OR gate 218 is driven to a low state, turning off n-channel FET 220, and preventing pulses of external synchronization signal 24 from appearing at node 231 and as internal synchronization signal 76.

After output Q12 of counter 206 has gone to a high state, upon the next occurrence of both output Q10 and output Q6 of counter 206 going to a high state ($2^9 + 2^5$ counts, or 1.275 milliseconds, later), the output of AND gate 262 will go to a high state. This is because both outputs Q6 and Q10 of counter 206 are in a high state, and because the output of exclusive NOR gate 236 is latched to a high state via OR gate 214 and exclusive NOR gate 216. When the output of AND gate 262 goes to a high state, the oscillator of counter 206 will be stopped, since a high voltage will be driven via diode 264 which will hold RC network 208 in one state. This will not only stop the oscillation of counter 206 but will also hold the count at the outputs of counter 206, in effect waiting for a pulse of external synchronization signal 24.

A pulse of external synchronization signal 24 will reset counter 206 because the output of AND gate 262 is at a high state and, since the output of amplifier 260 is an input to NAND gate 252, such a pulse of external synchronization signal 24 will appear as a positive pulse at an input of NAND gate 252 after being amplified by amplifiers 222 and 260. At this time, the output of NAND gate 252 will be driven to a low state, in turn driving the output of NAND gate 248 to a high state and, since the output of exclusive NOR gate 254 is connected to the reset input of counter 206, will cause a high output of exclusive NOR gate 254 and a positive pulse at the reset input of counter 206, thereby resetting all "Q" outputs of counter 206 to a low state. Counter 206 will then again begin its count from zero upward, since the reset of counter 206 sends outputs Q6 and Q10 of counter 206 to a low state, thereby driving the output of AND gate 262 to a low state and allowing the oscillator of counter 206 to begin operation again. Note, however, that during this time the output of OR gate 226 has remained low, thereby keeping disable signal 228 low and keeping static inverter 1 in a standby condition; this is because the output of AND gate 238 is also in a low state while the output of AND gate 266 is in a low state thereby keeping the output of AND gate 266 and the output of AND gate 224 in a low state. Similarly, since the output of AND gate 266 has remained in the low state, synchronization monitor signal 234, via AND gate 230 and circuitry 232, has remained in a low state during this time.

Once counter 206 has begun counting again, output Q10 of counter 206 will next go to a high state $2^9$ counts (1.2 milliseconds) later, after which time output Q6 of counter 206 will remain in a low state for $2^5$ counts (or 75 microseconds). The output of AND gate 238 will be in a high state during these $2^5$ counts because the output of NAND gate 240 is in a high state whenever output Q6 of counter 206 remains low. Because the output of exclusive NOR gate 236 is latched to a high state, and because the output of NAND gate 240 is in a high state, the output of AND gate 242 is driven to a high state. Note that during this time, the output of AND gate 262 also remains at a low state as long as the Q6 output of counter 206 remains low, and therefore counter 206 is continuing to count. Since the output of AND gate 242 is at a high state, a positive pulse from external synchronization signal 24 will appear, after amplification by amplifiers 222 and 260, at an input to NAND gate 250. The simultaneous combination of a high state at the output of AND gate 242 plus the presence of the positive pulse at the output of amplifier 260 will, via NAND gates 250 and 248 and exclusive NOR gate 254, reset counter 206. If the reset occurs at this time, through NAND gate 250 only, static inverter 1 will be considered synchronized. This is because a pulse of external synchronization signal 24 has occurred during the "window" of time of a length of $2^5$ counts, beginning $2^9$ counts after a prior pulse. Using the frequencies in this embodiment, static inverter 1 will be considered synchronized if a pulse of external synchronization signal 24 occurs from 1.2 milliseconds to 1.275 milliseconds after a prior pulse, corresponding to a frequency range of approximately 778 Hz to 826 Hz. In addition, since the output of AND gate 238 is at a high state, a pulse appearing at the output of amplifier 260 during this "window" will also appear at the input to AND gate 266. Since the output of OR gate 214 is latched to a high state, a high state at the output of AND gate 224 will occur, which will in turn drive a high state at the output of OR gate 226, driving disable signal circuitry 228 high, thereby enabling static inverter 1 to begin operation. Once the output of AND gate 224 is driven high by this pulse, RC network 225 will keep the output of OR gate 226 high for a period of time after the pulse ends and extending into the next time "window," since the time constant of RC network 225 in this embodiment is 0.4 seconds. Therefore disable signal 228 is kept high even through AND gate 224 only provides a short pulse to OR gate 226. In addition, since the output of AND gate 266 is at a high state when a pulse appears at the output of amplifier 260 during this "window", the output of AND gate 266 will drive the output of OR gate 218 high, turning on n-channel FET 220 and allowing the pulse of external synchronization signal 24 to appear at node 231 and again trigger master oscillator 8. Furthermore, since the pulse of external synchronization signal 24 will appear simultaneously at the output of amplifier 260 and amplifier 268, driving the output of AND gate 270 to a high state, the output of exclusive NOR gate 272 will be driven to a high state as well because the output of AND gate 266 is also high. The output of AND gate 270 is controlled to a single pulse even if the pulses at the outputs of amplifiers 260 and 268 are not perfectly coincident. This is because the value of resistor 267 in this embodiment (7.5 kilo-ohms) is lower than the value of resistor 269 (27 kilo-ohms); the differentiations performed at the inputs to amplifiers 260 and 268 (the value of capacitor 271 being approximately the same as that of capacitor 273) therefore provide a shorter pulse to the input of amplifier 260 than to the input of amplifier 268. Amplifier 260 thus will have a shorter output pulse than amplifier 268, and will control the width of the output of AND gate 270. Since the pulse at the output of amplifier 260, through AND gate 266, controls the other input to exclusive NOR gate 272, both inputs arrive essentially simultaneously. The high output of exclusive NOR gate 272 will reverse bias diode 274, allowing two of the inputs of AND gate 230 to go to a high state. The other input of AND gate 230 is also at a high state at this time, since the output of OR gate 226 is at a high state. Therefore, via circuitry 232, synchronization monitor signal 234 will go to a high state, alerting the operator that static inverter 1 is synchronized.

However, if the positive pulse of external synchronization signal 24 does not occur in the "window" after the time that output Q10 of counter 206 goes high and before the time that output Q6 of counter 206 goes high, synchronization will not occur. Once output Q6 of counter 206 goes high $2^5$ counts, or 75 microseconds, after output Q10 of counter 206 has gone high (which will occur if no pulse of external synchronization signal 24 appears during this time to reset counter 206), the output of AND gate 262 will go to a high state and the oscillator of counter 206 will be stopped. Even if a positive going pulse of external synchronization signal 24 appears after this time, since the output of AND gate 238 is at a low state because output Q6 of counter 206 remains at a high state once the oscillator of counter 206 has stopped, the output of AND gate 266 will remain at a low state, keeping the disable signal 228 from going to a high state, and keeping static inverter 1 in standby condition. In addition, since the output of AND gate 266 will remain low, n-channel FET 220 will remain off since the output of OR gate 218 will be low, and the pulse of external synchronization signal 24 will not appear at node 231. Similarly, since the output of OR gate 226 is at a low state because the output of AND gate 266 is low, the output of AND gate 230 is held to a low state and, via circuitry 232, synchronization monitor signal 234 will be held to a low state, thereby alerting the operator that static inverter 1 is not synchronized. However, if a pulse of external synchronization signal 24 does occur after output Q6 of counter 206 has gone high, counter 206 will still be reset, as described above, via NAND gates 252 and 248, and exclusive NOR gate 254. The count will then begin anew, and will again allow a subsequent pulse appearing in the "window" between output Q10 of counter 206 going high, and output Q6 of counter 206 going high to synchronize and enable static inverter 1.

In this embodiment, as stated above, synchronization monitor circuit 26 allows positive pulses of external synchronization signal 24 to keep static inverter 1 synchronized as long as such pulses occur between 1.2 milliseconds and 1.275 milliseconds apart (or between $2^9$ and $2^9 + 2^5$ counts of counter 206). Therefore, in this embodiment as long as external synchronization signal 28 has a frequency between approximately 785 Hz and approximately 833 Hz, static inverter 1 will remain synchronized.

It should be apparent that, merely by selectively choosing the outputs of counter 206, the time windows may be adjusted. For example, if rather than output Q6 of counter 206, output Q7 (corresponding to $2^6$ counts) is used, and if the frequency of oscillation of counter 206 is still 423 kHz, the time window in which the positive pulses of external synchronization signal 24 can appear in order to keep static inverter 1 synchronized is lengthened from 75 microseconds to 150 microseconds, allowing the frequency of external synchronization signal 24 to range from 734 Hz to 826 Hz. In addition, by changing output Q10 of counter 206 to a different output or outputs, the center frequency of the allowable range can be changed. Furthermore, the center frequency of the allowable range can be fine tuned by means of potentiometer 212B.

Figure 7A is a timing diagram which illustrates the operation of synchronization monitor circuit 26. The "window" is represented by the waveform labeled "242 output", which illustrates the output of AND gate 242. If a pulse at the output of amplifier 260 (shown on Figure 7A as "260 output") appears during this time, as described above, counter 206 will reset and the count will start over; on Figure 7 this condition occurs at the time indicated "valid pulse." Figure 7A also illustrates that the "window" shown by the output labeled "242 output" is derived by the combination of the output of OR gate 214 at a high state ("214 output" in Figure 7A), the Q10 output of counter 206 at a high state ("counter 206-(Q10)") and the Q6 output of counter 206 at a low state ("counter 206-(Q6)").

Referring back to Figure 7, it is apparent that if a pulse were driven at node 231, rather than from external synchronization signal 24, this pulse would pass through the body diode of n-channel FET 220 and appear at the input to amplifier 227, just as a pulse from external synchronization signal 24 passes through the body diode of n-channel FET 204 and appears at the input of amplifier 222. Therefore, an internally generated synchronization signal could similarly be monitored by synchronization monitor circuit 26, and enable static inverter 1 without the need for an external synchronization signal. Therefore, the circuit illustrated in Figure 7 not only serves as synchronization monitor circuit 26, but also as frequency monitor circuit 29 of Figure 1, as the same techniques used to monitor external synchronization signal 24 can be used to monitor the frequency of operation of static inverter 1 itself, when operating alone. In addition, since RC network 200 blocks any DC external voltage from affecting synchronization monitor 26, a fault causing a short circuit of external synchronization signal 24 to a high DC voltage or to ground, preventing any pulses of external synchronization signal 24, will not affect the operation of static inverter 1 if such internally generated pulses are used. Static inverter 1, in this embodiment, uses synchronization pulse generator 16 (shown in Figure 1) to provide these pulses and to allow static inverter 1 to be enabled and synchronized, if static inverter 1 is operating alone or if static inverter 1 is operating in parallel with other static inverters and external synchronization signal 24 is shorted to a high DC voltage or to ground.

Figure 7B shows, in schematic form, synchronization pulse generator 16. Assuming master oscillator 8 to be triggered by internal synchronization signal 76, the carry-out signal of divide-by-ten (decade counter) 82 will be an 800 Hz square wave, as discussed above. This 800 Hz square wave is connected to the clock input of R-S flip-flop 340 and will, because the "Q̄" output of R-S flip-flop 340 is connected to its "D" input, cause the "Q" and "Q̄" outputs to each alternate between a low and high state at 400 Hz since R-S flip-flop 340 is toggled by the low-to-high transitions of the carry out signal; in effect the "Q" and "Q̄" outputs are 400 Hz square waves phase-shifted from each other by 180 degrees. These square waves are each differentiated by R-C networks 342 and 344 so that the signal appearing at the base of p-n-p transistor 350 is a series of negative pulses at 400 Hz, and so that the signal appearing at the base of p-n-p transistor 352 is a series of negative pulses also at 400 Hz, but phase-shifted 180 degrees from the pulses at the base of p-n-p transistor 350.

Zener diode 354 is a 10 volt zener diode, and zener diode 356 is a 5 volt zener diode. Because of zener diode 354, the emitters of p-n-p transistors 350 and 352 are biased at 10 volts. When a negative pulse appears at the base of p-n-p transistor 352, p-n-p transistor 352 conducts and a positive voltage pulse of 10 volts appears at node 231. However, when a negative pulse appears at the base of p-n-p transistor 350, because of the 5 volt voltage drop across zener diode 356, a 5 volt positive pulse will appear at node 231. Therefore, whenever master oscillator 8 is operating, a series of pulses, with alternating magnitudes of 10 volts and 5 volts will appear at node 231 with a frequency of 400 Hz (10 volt pulse to 10 volt pulse).

Note also that the 10 volt bias provided by zener diode 354 also appears at the inverting input of comparator 358. Because of the voltage divider created by resistors 360, 362, 364 and 366 (in this embodiment, with the values 5.1 kilo-ohms, 6.2 kilo-ohms, 5.1 kilo-ohms, and 1.0 kilo-ohms respectively) the voltage at the non-inverting input of comparator 358 is less than 10 volts (in this embodiment, 9.7 volts). Because of this, the output of comparator 358 is low, keeping internal synchronization signal 76 low, and allowing master oscillator 8 to run freely. Comparator 368 also has its non-inverting input biased by the same voltage divider but between resistor 360 and resistor 362, biasing this input at 4.39 volts in this embodiment. The inverting input of comparator 368 is connected to node 231 so that when any pulse at node 231 exceeds 4.39 volts, such as the 5v/10v pulses generated by synchronization pulse generator 16, as discussed above, or such as similar pulses coming to node 231 via external synchronization signal 24 and synchronization monitor circuit 26 discussed above, the output of comparator 368 will be driven low, thereby pulling down the inverting input of comparator 358 to a voltage less than 9.7 volts. Therefore, because of the pulse at node 231, the output of comparator 358 (internal synchronization signal 76), is driven high, thereby presenting a high level input or NOR gate 114 via node 76. However, since this pulse is generated by master oscillator 8 itself, but is delayed through the operation of synchronization pulse generator 16, node 76 will go high while the other input to NOR gate 114 is already high; this high pulse at node 76 will therefore be ignored by NOR gate 114. However, if for some reason the synchronization of master oscillator 8 has been disturbed, this high pulse at node 76 generated by synchronization pulse generator 16 will again trigger master oscillator 8.

The alternating nature of the 10v/5v pulses at node 231 generated by p-n-p transistors 350 and 352 (via zener diodes 354 and 356) is useful for controlling phase relationships within within static inverter 1 and among parallel static inverters. First of all, the "Q" output of R-S flip-flop 340 is connected to steering network 58 so that FET drivers 62 can be phased in relationship with the 10v/5v pulse series generated by the "Q" (and "Q̄") outputs of R-S flip-flop 340. Secondly, as shown in Figure 7B, comparator 370 is biased so that its inverting input is at 9.7 volts (using the same voltage divider as comparator 358). If a 10 volt pulse appears at node 231, the output of comparator is driven high, sending a positive signal to the set input of R-S flip-flop 340, setting its "Q" output to a high state. Note that a 5 volt pulse at node 231 will not accomplish this. In this way, the polarity of the Q and Q̄ outputs can be synchronized with a 10v/5v pulse series appearing at node 231 from external synchronization signal 24 through frequency monitor circuit 26, as well as by the 10v/5v pulse series generated by synchronization pulse generator 16.

Referring back to Figure 7, it should now be apparent that pulses generated by synchronization pulse generator 16 of static inverter 1 itself will appear at node 231 and pass through the body diode of n-channel FET 220 to the input of amplifier 222. Therefore, if no external synchronization signal 24 is provided (e.g., if static inverter 1 is not connected in parallel with any other static inverter), since the 10v/5v pulse series generated by synchronization pulse generator 16 is nominally at 800 Hz, synchronization monitor circuit 26 will operate as described above (only with the pulses at node 231 generated by synchronization pulse generator 16 replacing pulses of external synchronization signal 24) and static inverter 1 will be enabled and synchronized as described above. In addition, referring still to Figure 7, whenever disable signal 228 is high (i.e., static inverter 1 is enabled) n-channel FET 204 is turned on, allowing pulses appearing at node 231 to pass through the body diode of n-channel FET 220 and appear at the node where external synchronization signal 24 is applied. In this way, static inverter 1 is itself providing an external synchronization signal which could be used as an external synchronization signal to another static inverter, if desired.

When two or more static inverters are connected in parallel, it should be apparent that, referring still to Figure 7, a conflict will initially arise at the input to amplifier 222 between internally generated pulses at node 231 and external synchronization signal 24. As a practical matter, though, one of the conflicting series of pulses will be at a slightly higher frequency than the other. Referring also to Figure 7A, it should be apparent that after a given reset of counter 206 has occurred, the next pulse occurring within the "window" illustrated by "242 output" will reset counter 206 and synchronize static inverter 1. If another pulse occurs shortly after this pulse resets counter 206 (i.e., prior to output Q10 of counter 206 going high again), this pulse will be ignored. In this way, the slightly higher frequency pulse series will control synchronization of static inverter 1. In the case that external synchronization signal 24 is of a higher frequency than synchronization pulse generator 16 (but within the frequency range required by synchronization monitor circuit 26), the pulses of external synchronization signal 24 will pass through n-channel FET 220 as described above, appear at node 231 and, as shown on Figure 7B and described above, will trigger master oscillator 8 via comparators 368 and 358. Synchronization of static inverter 1 will thus be controlled by external synchronization signal 24. However, in the event that the pulses generated by synchronization pulse generator 16 are of a slightly higher frequency than external synchronization signal 24, it will control the parallel static inverter or inverters in the same manner as described above where static inverter 1 was controlled by a slightly higher frequency external synchronization signal 24.

Static inverter 1 may, of course, also be controlled by an external source of 10v/5v pulses serving as external synchronization signal 24, as long as it is of a slightly higher frequency than pulses generated by synchronization pulse generator 16 of static inverter 1. Referring to Figure 3, when oscillator control node 372 is pulled near ground, one side of capacitor 374 is near ground potential. Therefore, when the output of NOR gate 116 goes high during the oscillation cycle, capacitors 118 and 374 will be effectively in parallel, creating a longer time constant than before and slowing down the oscillation frequency of master oscillator 8, ensuring that the frequency of master oscillator 8 is below the frequency of external synchronization signal 24. Referring to Figure 7B, oscillator control node 372 is driven low by a DC voltage appearing at external node 371 higher than the voltage at the non-inverting input of amplifier 373 (in this embodiment, 4.39 volts). Therefore, the operator of static inverter 1 may slow down the frequency of master oscillator 8 by providing a DC voltage grater than 4.39 volts at external node 371, which will drive a low voltage at the output of amplifier 373 and therefore a low voltage at node 76. If external node 371 is left floating, capacitor 374 will have no effect on master oscillator 8 because the output of amplifier 373 is of the open-collector type. One possible use of this technique is in three-phase systems, where the operator wishes to have one static inverter for each phase, with each static inverter synchronized, but 120 degrees phase shifted from each other. This can be done if an external source provides a DC voltage greater than 4.39 volts at external node 371 for each of the three static inverters to ensure that an external synchronization signal, such as a 10v/5v pulse series to each of the three static inverters at the same frequency but phase shifted 120 degrees from one another, can control all three static inverters. In this way, connection of the outputs of the static inverters in parallel will provide a three-phase power output, since each of the three static inverters will be synchronously providing power in its proper phase.

Low Voltage Operation

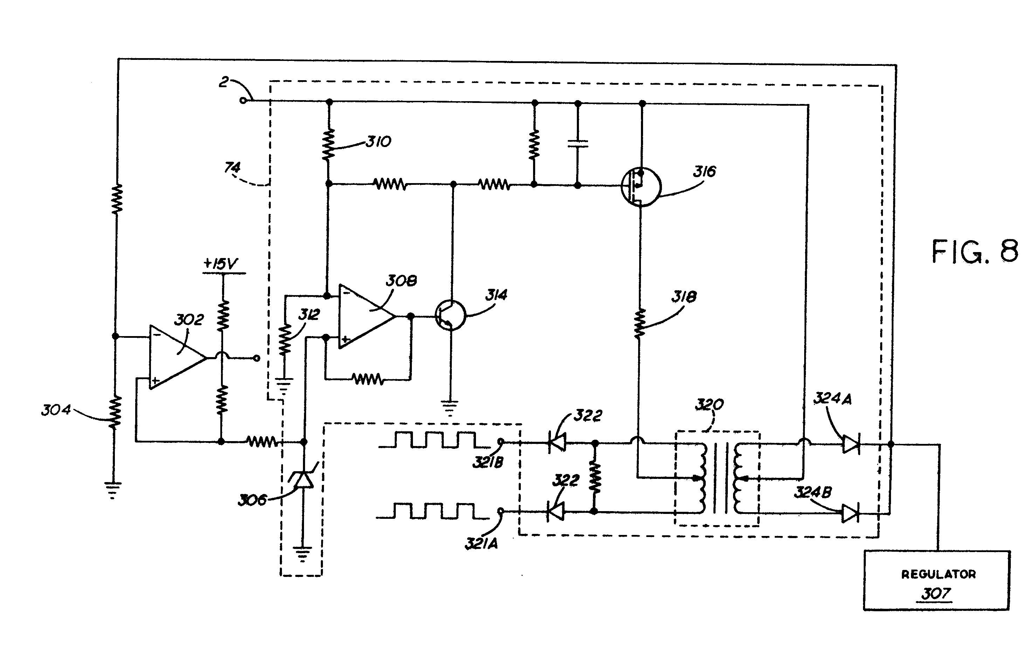

In order to provide sufficient drive level for the drive circuitry of static inverter 1, specifically FET drivers 65A/B/C/D, DC input voltage signal 2 must be maintained at a level above at least 15 volts. Voltage booster 74, shown in Figure 1, is used in this embodiment to perform this function. In this embodiment, static inverter 1 does not begin operation until the DC input voltage signal 2 has reached 17 volts during startup. Referring to Figure 8, which contains a schematic diagram of voltage booster 74, DC input voltage signal 2 will pass through resistor 300 (in this embodiment 56.2 kilo-ohms) via the secondary of transformer 320 and diodes 324A and 324B, and will appear at the node connecting the inverting input of amplifier 302 and resistor 304 (in this embodiment 34.8 kilo-ohms). The noninverting input of amplifier 302 is set by zener diode 306 to a reference level of 6.8 volts. Once DC input voltage signal 2, as divided by the voltage divider created by resistors 300 and 304, achieves a voltage greater than 6.8 volts at the noninverting input of amplifier 302, the output of amplifier 302 will go to a low state; disable signal 228 is responsive to the output of amplifier 302 in such a way that a low state at the output of amplifier 302 will enable operation of static inverter 1. The minimum voltage of DC input voltage signal 2 required to switch amplifier 302 to a low state is, in this embodiment, approximately 17.8 volts. Zener diode 306 similarly sets a similar reference level of 6.8 volts at the noninverting input of amplifier 308. Similarly, DC input voltage signal 2 feeds resistor 310 (in this embodiment 30 kilo-ohms) and is then connected to the inverting input of amplifier 308, with resistor 312 (in this embodiment 15 kilo-ohms) connected to ground. At such time as DC input voltage signal 2, as divided by the voltage divider consisting of resistors 310 and 312, exceeds 6.8 volts, the output of amplifier 308 goes to a low state. In this embodiment, this is achieved when DC input voltage signal 2 is approximately 20.4 volts. Also, at this time, since the output of amplifier 308 is at a low state, n-p-n transistor 314 is turned off into a nonconducting state. Therefore, the gate of p-channel FET 316 is held at a high, nonconducting, state by DC input voltage signal 2.

The drain of p-channel FET 316 is connected, through resistor 318, to the center tap of the primary of center tapped transformer 320. The primary of transformer 320 is connected, through diodes 322A and 322B to FET drivers 65C and 65D, at nodes 321A and 321B, as shown in Figure 2A. Therefore, alternate positive going square waves appear at diodes 322, (with the pulses at diode 322A phase shifted by 180 degrees from the pulses at diode 322B). Because these pulses reverse bias diodes 322A and 322B, and since p-channel FET 316 is not conducting, no current passes through the primary of transformer 320. The center tap of the secondary of transformer 320 is connected directly to DC input voltage signal 2. Therefore, a DC voltage corresponding to the voltage of DC input voltage signal 2 passes through both halves of the secondary of transformer 320, through diodes 324A and 324B, and on to voltage regulator 307 which provides the regulated voltage for the control logic of static inverter 1 and for FET drivers 65A/B/C/D. In the event that DC input voltage 2 falls from its nominal 28 volt value to, in this embodiment, approximately 17 volts (or lower). the voltage at the inverting input to amplifier 308 will fall sufficiently below the 6.8 volts of the noninverting input amplifier 308 to change the state of the output of amplifier 308 to a high state. Once this occurs, the output of amplifier 308 will reach a voltage high enough to turn on n-p-n transistor 314, such that n-p-n transistor 314 conducts. When n-p-n transistor 314 conducts, the gate voltage of p-channel FET 316 is pulled to a low voltage, causing p-channel FET 316 to conduct and in effect connect DC input voltage signal 2 to the center tap of the primary of transformer 320, causing current to flow through the primary of transformer 320. This current through the primary of transformer 320 will pass alternately through diodes 322A and 322B and through FET drivers 65C and 65D, shown in Figure 2A, via nodes 321A and 321B. However, since the current passing through the primary of transformer 320 induces a voltage in the secondary of transformer 320, the voltage of DC input voltage 2, as seen at the secondary of transformer 320. is thereby boosted by the current passing through the primary of transformer 320. The voltage going to voltage regulator 307 is thereby kept at a level sufficient for proper operation. As shown in Figure 8, the voltage boosted by the secondary of transformer 320 also appears at the inverting input of amplifier 302 via the voltage divider of resistors 300 and 304, which ensures that the output of amplifier 302 remains low, thereby ensuring that static inverter 1 remain enabled. In this embodiment, if DC input voltage 2 falls as low as 10 volts, voltage booster 74 will be able to boost the voltage to a level high enough to provide sufficient bias and drive to the logic circuitry of static inverter 1 and FET drivers 65A/B/C/D. Output Shunt FETs

If the load at the output of static inverter 1 has a large reactive component, this reactance will store energy provided by static inverter 1. Since the output of static inverter 1 is an AC output, if the energy stored in this reactance is not somehow absorbed, it will disturb the shape of the output waveform. Therefore, it is desirable to make static inverter 1 a "four-quadrant" system by providing shunts near the output which will safely absorb the energy stored by a reactive load.

N-channel shunt FETs 402A and 402B are shown in Figure 2A as each connected from one end of inductors 172A and 172B, respectively, to the common node. It is apparent that if the gates of shunt FETs 402A and 402B are positively biased at nodes 404A and 404B (with respect to nodes 405A and 405B respectively), shunt FETs 402A and 402B would conduct. This would allow a positive voltage appearing at inductor 172A to be shorted to common through shunt FET 402A, and similarly would allow a negative voltage appearing at inductor 172B to be shorted to common through shunt FET 402B. This shorting action allows energy stored in a reactive load at the output of static inverter 1 to be absorbed through shunt FETs 402A and 402B. Note that positive voltages would pass through shunt FET 402A only and that negative voltages pass through shunt FET 402B only, because of diodes 406A and 406B.

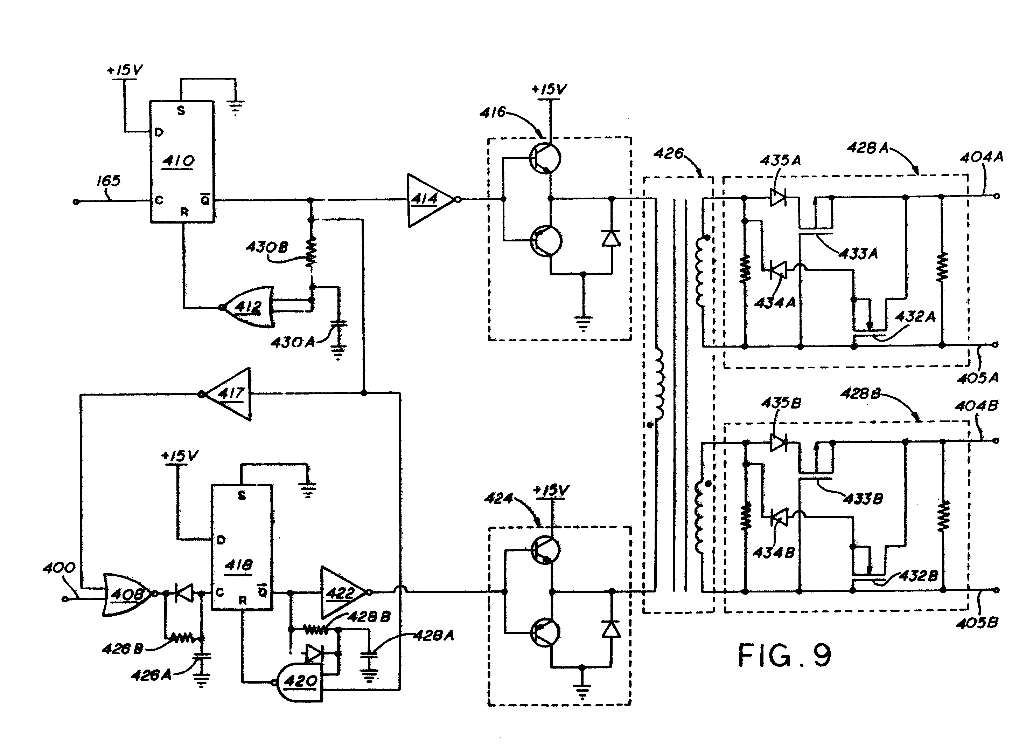

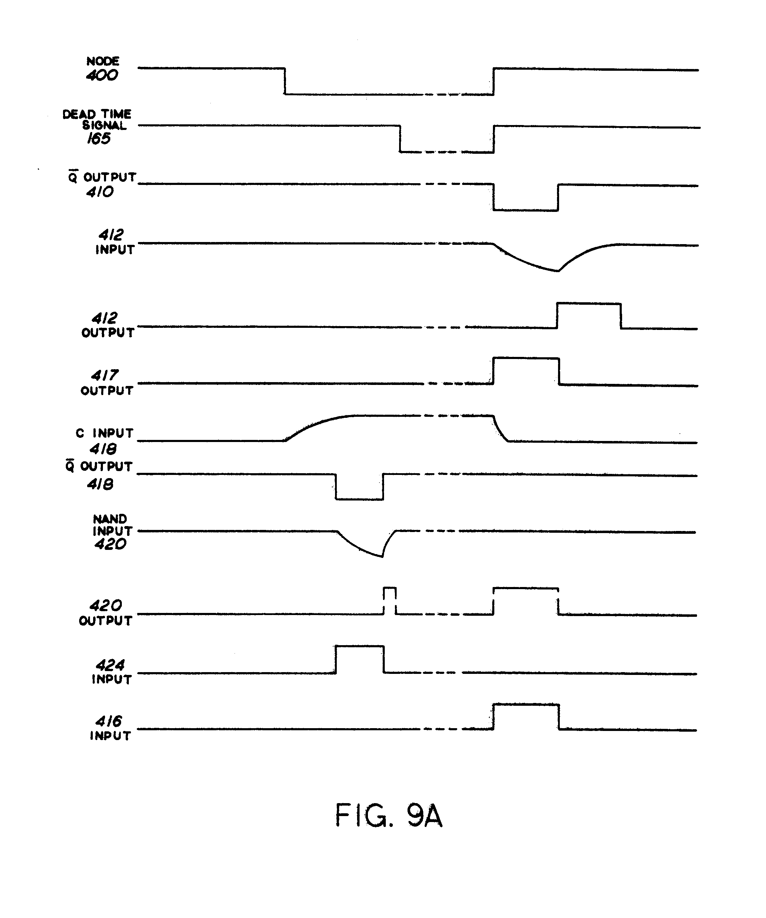

Shunt FETs 402A and 402B are controlled by the circuit illustrated in Figure 9 so that they are conducting only during such time as no current is being sourced by FET drives 65A/B/C/D through transformer 168; if shunt FETs 402A and 402B were to conduct during such time as transformer 168 was sourcing current, the output waveform of static inverter 1 would be disturbed. Referring to Figure 9, node 400 receives the "Q" output from R-S flip-flop 164 shown on Figure 2A, and is connected to one input of NOR gate 408. Dead time signal 165 from Figure 2A appears as the clock input to R-S flip-flop 410 of Figure 9.

In the timing diagram of Figure 9A, the time axis begins with node 400 high and dead time signal 165 high. representing that power is being sourced through FET drivers 65A/B/C/D. At this time, the "Q̄" output of R-S flip-flop 410 is high, since the high output of NOR gate 412 has reset R-S flip-flop 410. Therefore, since the output of inverter 414 is low, the output of transistor pair 416 is effectively at ground potential. In addition, since the "Q̄" output of R-S flip-flop 410 is high, the output of inverter 417 (connected to the other input of NOR gate 408) is low, causing the output of NOR gate 408 and the "C" input of R-S flip-flop 418 to be low. Since R-S flip-flop 418 has been reset, because of the status of NAND gate 420, the "Q̄" output of R-S flip-flop 418 is high, holding low the output of transistor pair 424 via inverter 422, similarly as described above. Since the outputs of both transistor pair 416 and transistor pair 424 are low, no current is passing through the primary of transformer 426, inducing no voltage at the secondaries of transformer 426 and causing no potential at node 404A relative to node 405A (and no potential at node 404B relative to node 405B) which, referring to Figure 2A, keeps shunt FETs 402A and 402B both non-conductive.

As discussed above in reference to Figure 2A, when PWM switchmode regulator 6 has determined that no more current should be sourced in a given 120 kHz cycle, node 59 will be pulled low, causing NAND gate 35 to reset R-S flip-flop 164. This action drives the "Q" output of R-S flip-flop 164, and node 400, to go low; this is reflected in the waveform of figure 9A labeled "node 400". As node 400 goes low, the output of NOR gate 408 goes high, charging capacitor 426A through resistor 426B, and presenting a delayed positive pulse at the "C" input of R-S flip-flop 418, as reflected in the "C input-418" waveform of Figure 9A. This causes the "Q̄" output of R-S flip-flop 422 to go low, since the "D" input of R-S flip-flop 418 is at 15 volts. The low "Q̄" output of R-S flip-flop 418 discharges capacitor 428A through resistor 428B, pulling an input of NAND gate 420 low ("NAND input-420" waveform of Figure 9A), which causes a high state at the output of NAND gate 420. This causes R-S flip-flop 418 to reset, pulling the "Q̄" output of R-S flip-flop 418 to a high state. As a result of this operation, a brief positive pulse has appeared at the input of transistor pair 424 ("424 input" of Figure 9A). This pulse drives the output of transistor pair 424 high and since the output of transistor pair 416 is low, causes a pulse of current through the primary of transformer 426. This pulse of current induces a positive voltage pulse at the secondaries of transformer 426 and, via networks 428A and 428B, presents a positive voltage pulse at nodes 404A and 404B relative to nodes 405A and 405B, respectively. The positive voltages induced at the secondaries of transformer 426 serve to turn off n-channel transistors 432A and 432B, turn on p-channel transistors 433A and 433B, reverse bias diodes 434A and 434B and forward bias diodes 435A and 435B. As discussed above, this potential pulse makes shunt FETs 402A and 402B, shown in Figure 2A, conductive (shunt FETs 402A and 402B being n-channel devices). The potential remains positive at the gates of shunt FETs 402A because of the inherent gate capacitance of shunt FETs 402A and 402B and because of diodes 435A and 435B. Therefore, for a period of time following the disabling of FET drivers 65A/B/C/D (shown in Figure 2A) by PWM switchmode regulator 6, shunt FETs 402A and 402B are made conductive so that energy stored by a reactive load will pass through inductors 172A and 172B and will be safely shunted to common by shunt FETs 402A and 402B.

After node 400 has gone low, the next event impacting shunt FETs 402A and 402B is dead time signal 165 going low for a brief period upon the next toggle of the 120 kHz clock, as discussed above in relation to Figure 2A; this pulse is shown on Figure 9A as the waveform labeled "dead time signal 165". Upon completion of the low pulse of dead time signal 165, the clock input of R-S flip-flop 410 will cause the "Q̄" output of R-S flip-flop 410 to go low, since the "D" input of R-S flip-flop 410 is at 15 volts. However, once capacitor 430A is discharged through resistor 430B to a "zero" level, NOR gate 412 will drive a high state at its output, causing R-S flip-flop 410 to be reset, and causing the "Q̄" output of R-S flip-flop 410 to be driven high. Therefore, the low state of the "Q̄" output of NOR gate 410 remains only for a brief period of time, until capacitor 430A is discharged to a "zero" level. As a result of this low pulse, via inverter 414, a pulse of positive voltage is presented to the input of transistor pair 416, driving a high voltage at the output of transistor pair 416. Since transistor pair 424 has a low voltage at its output at this time, a current passes through the primary of transformer 426 which induces a voltage of the opposite polarity (opposite from that induced by a high output of transistor pair 424) at the secondaries of transformer 426. Via the operation of networks 428A and 428B (n-channel transistors 432A and 432B conducting, p-channel transistors 433A and 433B not conducting, diodes 434A and 434B forward biased and diodes 435A and 435B reversed biased) a positive potential will appear at nodes 405A and 405B, relative to nodes 404A and 404B respectively, discharging the inherent gate capacitance of shunt FETs 402A and 402B, thereby ensuring that shunt FETs 402A and 402B are non-conductive. Therefore, for a short period of time following the low voltage pulse of dead time signal 165, shunt FETs 402A and 402B are turned off "hard" by the negative pulses generated by the circuit shown in Figure 9, ensuring that shunt FETs 402A and 402B remain non-conductive when static inverter 1 is sourcing power, and not disturbing the operation of static inverter 1.

Although this invention has been described in its preferred form in some particularity, it is understood that this disclosure of the preferred embodiment has been made by way of example only, and that numerous changes in the details of the circuits and also in the combination and arrangement of circuit elements may be made without departing from the spirit and scope of the invention as hereinafter claimed.

**Claims**

1. A circuit for generating a periodic electrical signal in a static inverter, which comprises:
    a capacitor;
    a plurality of resistors connected in series with each other and in series with the capacitor;
    means for periodically charging and discharging the capacitor through the resistors; and

**0 218 414**

means for selectively providing a low impedance path across one or more of the resistors so that a periodic electrical signal of a predetermined shape appears at the capacitor.

2. A circuit as recited in claim 1, wherein the means for providing low impedance paths comprises:

a plurality of switches, each of which is connected in parallel to one of the resistors. and each of which is responsive to a control signal to selectively provide a low impedance path across the resistor in parallel with said switch; and

means for providing the control signals to the switches at predetermined times.

3. A circuit as recited in claim 2, wherein the means from providing control signals comprises:

means for providing a periodic series of pulses; and

means, responsive to the pulses, for periodically generating the control signal to each of the switches.

4. A circuit as recited in claim 2, wherein the charging and discharging means comprises:

means for providing a charging voltage;

means for providing a discharging voltage; and means for selectively connecting the series of resistors to either the charging voltage or the discharging voltage.

5. A circuit as recited in claim 3, wherein the charging and discharging means comprises:

means for providing a charging voltage;

means for providing a discharging voltage; and means, responsive to the pulses, for selectively connecting the series of resistors to either the charging voltage or the discharging voltage.

6. A circuit as recited in claim 4 or 5, further comprising:

means for comparing the output power of the static inverter to the output power of one or more other static inverters connected in parallel with the first static inverter;

means, responsive to the comparing means, for modulating the voltages to which the capacitor is charged and discharged so that the amplitude of the periodic analog electrical signal is adjustable according to the comparison of the output power of the static inverter to the output power of the other static inverters.

7. A circuit as recited in claim 6, wherein the means for providing a charging voltage comprises:

a transistor acting as a variable resistor, having two terminals comprising the resistor terminals, having a first resistor terminal connected to a first voltage, and having a third control terminal; a first resistor connected between the second resistor terminal of the transistor and a second voltage higher in magnitude than the first voltage; and

means for connecting the control terminal of the transistor to the comparing means so that the resistance between the resistor terminals of the transistor is modulated by the comparing

means in such a manner that the charging voltage, generated at the point between the first resistor and the second resistor terminal of the transistor, is modulated responsive to the comparing means.

8. A circuit as recited in claim 7, wherein the means for providing a discharging voltage comprises:

a second resistor connected between the first voltage and the first resistor terminal of the transistor; and

means for connecting the control terminal of the transistor to the comparing means so that the resistance between the resistor terminals of the transistor is modulated by the comparing means in such a manner that the discharging voltage, generated at the point between the second resistor and the first resistor terminal of the transistor, is modulated responsive to the comparing means.

9. A circuit as recited in claim 6, wherein the means for providing a charging voltage comprises:

a field effect transistor having its source connected to a first voltage;

a first resistor connected between the drain of the field effect transistor and a second voltage; means for connecting the gate of the field effect transistor to the comparing means so that the charging voltage, generated at the point between the drain of the field effect transistor and the first resistor, is modulated by the field effect transistor in response to the comparing means.

10. A circuit as recited in claim 9, wherein the means for providing a discharging voltage comprises:

a second resistor connected between the source of the field effect transistor and the first voltage; and

means for connecting the gate of the field effect transistor to the comparing means so that the discharging voltage, generated at the point between the source of the field effect transistor and the second resistor, is modulated by the field effect transistor in response to the comparing means.

11. A circuit for generating a periodic electrical signal in a static inverter, which comprises:

means for providing a periodic series of pulses; a counter responsive to the pulse providing means;

a capacitor;

a plurality of resistors connected in series with each other and in series with the capacitor;

a plurality of switches, each of which is connected in parallel with one of the resistors, and each of which is responsive to a control signal to selectively provide a low impedance path across the resistor connected in parallel with said switch;

means responsive to the counter for periodically charging and discharging the capacitor through the resistors; and

means for providing the control signals to the switches, connected to the counter in such a manner that the switches are controlled to create a periodic electrical signal of a predetermined shape at the capacitor.

12. A circuit as recited in claim 11, wherein the means from providing a periodic series of pulses comprises:
an oscillator circuit.

13. A circuit as recited in claim 12, where the means for providing a periodic series of pulses further comprises:
a phase lock loop circuit, responsive to the oscillator circuit, connected between the oscillator circuit and the counter in such a manner that it provides the counter with a periodic series of pulses of a higher frequency than the pulses provided by the oscillator circuit.

14. A circuit as recited in claim 13, wherein the means for providing a periodic series of pulses further comprises:
a frequency divider circuit, responsive to the phase lock loop circuit, connected between the phase lock loop circuit and the counter in such a manner that it provides the counter with a periodic series of pulses of a frequency less than that of the output of the phase lock loop but greater than that of the oscillator circuit.

15. A circuit as recited in claim 12, wherein the charging and discharging means comprises:
means for providing a charging voltage;
means for providing a discharging voltage; and
means, responsive to the counter, for selectively connecting the series of resistors to either the charging voltage or the discharging voltage.

16. A circuit as recited in claim 15, further comprising:
means for comparing the output power of the static inverter to the output power of one or more other static inverters connected in parallel to the first static inverter; and
means responsive to the comparing means for modulating the voltages to which the capacitor is charged and discharged, so that the amplitude of the periodic analog electrical signal is adjustable according to the comparison of the output power of the static inverter to the output power of the other static inverters.

17. A circuit as recited in claim 16, wherein the means for providing a charging voltage comprises:
a transistor acting as a variable resistor, having two terminals comprising the resistor terminals, having a first resistor terminal connected to a first voltage, and having a third control terminal;
a first resistor connected between the second resistor terminal of the transistor and a second voltage higher in magnitude than the first voltage; and
means for connecting the control terminal of the transistor to the comparing means so that the resistance between the resistor terminals of the transistor is modulated by the comparing means in such a manner that the charging voltage. generated at the point between the second resistor and the second resistor terminal of the transistor, is modulated responsive to the comparing means.

18. A circuit as recited in claim 17, wherein the means for providing a discharging voltage comprises:
a second resistor connected between the first voltage and the first resistor terminal of the transistor; and
means for connecting the control terminal of the transistor to the comparing means so that the resistance between the resistor terminals of the transistor is modulated by the comparing means in such a manner that the discharging voltage. generated at the point between the second resistor and the first resistor terminal of the transistor, modulated responsive to the comparing means.

19. A circuit as recited in claim 16, wherein the means for providing a charging voltage comprises:
a field effect transistor having its source connected to a first voltage;
a first resistor connected between the drain of the field effect transistor and a second voltage;
means for connecting the gate of the field effect transistor to the comparing means so that the charging voltage, generated at the point between the drain of the field effect transistor and the first resistor, is modulated by the field effect transistor in response to the comparing means.

20. A circuit as recited in claim 19, wherein the means for providing a discharging voltage comprises:
a second resistor connected between the source of the field effect transistor and the first voltage; and
means for connecting the gate of the field effect transistor to the comparing means so that the discharging voltage, generated at the point between the source of the field effect transistor and the second resistor, is modulated by the field effect transistor in response to the comparing means.

21. A circuit as recited in claim 12. wherein the oscillator circuit comprises:
a first logic inverter circuit biased by an external power source:
a second logic inverter circuit biased by an external power source. and having its input connected to the output of the first inverter circuit:
a capacitor, having a positive temperature coefficient. connected on a first side to the output of the second inverter:
a first resistor connected between the input of the first inverter and the second side of the capacitor;
a second resistor connected between the input of the second inverter and the second side of the capacitor so that the output of the first inverter will oscillate at a frequency determined by the value of the capacitor and the value of the second resistor; and
a third resistor connected between the external power source and the first and second inverters. having such a value to substantially compensate the frequency of oscillation for temperature variations in the value of the capacitor.

22. A circuit as recited in claim 21, where the means for providing a periodic series of pulses further comprises:

a phase lock loop circuit, responsive to the oscillator circuit, connected between the oscillator circuit and the counter in such a manner that it provides the counter with a periodic series of pulses of a higher frequency than the pulses provided by the oscillator circuit.

23. A circuit as recited in claim 22, wherein the means for providing a periodic series of pulses further comprises:

a frequency divider circuit, responsive to the phase lock loop circuit, and connected between the phase lock loop circuit and the counter in such a manner that it provides the counter with a periodic series of pulses of a frequency less than that of the output of the phase lock loop but greater than that of the oscillator circuit.

24. A circuit as recited in claim 23, wherein the charging and discharging means comprises:

means for providing a charging voltage;

means for providing a discharging voltage; and means, responsive to the counter, for selectively connecting the series of resistors to either the charging voltage or the discharging voltage.

25. A circuit as recited in claim 21 further comprising:

means for comparing the output power of the static inverter to the output power of one or more other static inverters connected in parallel with the first static inverter; and

means, responsive to the comparing means, for modulating the voltages to which the capacitor is charged and discharged, so that the amplitude of the periodic analog electrical signal is adjustable according to the comparison of the output power of the static inverter to the output power of the other static inverters.

26. A circuit as recited in claim 25, wherein the means for providing a charging voltage comprises:

a transistor acting as a variable resistor, having two terminals comprising the resistor terminals, having a first resistor terminal connected to a first voltage, and having a third control terminal;

a first resistor connected between the second resistor terminal of the transistor and a second voltage higher in magnitude than the first voltage; and

means for connecting the control terminal of the transistor to the comparing means so that the resistance between the resistor terminals of the transistor is modulated by the comparing means in such a manner that the charging voltage. generated at the point between the first resistor and the second resistor terminal of the transistor, is modulated responsive to the comparing means.

27. A circuit as recited in claim 26, wherein the means for providing a discharging voltage comprises:

a second resistor connected between the first voltage and the first resistor terminal of the transistor; and

means for connecting the control terminal of the transistor to the comparing means so that the resistance between the resistor terminals of the transistor is modulated by the comparing means in such a manner that the discharging voltage, generated at the point between the second resistor and the first resistor terminal of the transistor, is modulated responsive to the comparing means.

28. A circuit as recited in claim 25, wherein the means for providing a charging voltage comprises:

a field effect transistor having its source connected to a first voltage;

a first resistor connected between the drain of the field effect transistor and a second voltage;

means for connecting the gate of the field effect transistor to the comparing means so that the charging voltage, generated at the point between the drain of the field effect transistor and the first resistor, is modulated by the field effect transistor in response to the comparing means.

29. A circuit as related in claim 28, wherein the the means for providing a discharging voltage comprises:

a second resistor connected between the source of the field effect transistor and the first voltage; and

means for connecting the gate of the field effect transistor to the comparing means so that the discharging voltage, generated at the point between the source of the field effect transistor and the second resistor, is modulated by the field effect transistor in response to the comparing means.

30. An oscillator circuit comprising:

a first logic inverter circuit biased by an external power source;

a second logic inverter circuit biased by an external power source, and having its input connected to the output of the first inverter circuit;

a capacitor, having a positive temperature coefficient, connected on a first side to the output of the second inverter;

a first resistor connected between the input of the first inverter and the second side of the capacitor;

a second resistor connected between the input of the second inverter and the second side of the capacitor so that the output of the first inverter will oscillate at a frequency determined by the value of the capacitor and the value of the first resistor; and

a third resistor connected between the external power source and the first and second inverters, having such a value to substantially compensate the frequency of oscillation for temperature variations in the value of the capacitor.

31. An oscillator circuit as recited in claim 30, wherein the first inverter circuit comprises a NOR gate, biased by an external power source. and having a first input near ground potential; and wherein the second resistor is connected between a second input of the first NOR gate and the second side of the capacitor.

32. An oscillator circuit as recited in claim 31, wherein the second inverter circuit comprises a NOR gate, biased by an external power source. having a first input connected to the output of the first NOR gate; and further comprising means for triggering the oscillator connected to a second input of the second NOR gate.

33. An oscillator circuit as recited in claim 30, 31 or 32, wherein the first resistor comprises a potentiometer for allowing external adjustment of the frequency of oscillation.

34. A circuit for synchronizing an oscillator in a static inverter with pulses of a synchronization signal, which comprises:

a switch having a closed, conductive state and an open, non-conductive, state for selectively connecting and disconnecting the synchronization signal to and from the oscillator;

means for sensing the presence of a pulse of the synchronization signal;

means, responsive to the sensing means, for measuring a first predetermined time period commencing with said pulse;

means, responsive to the means for measuring the first time period, for measuring a second predetermined time period commencing with the end of the first predetermined time period; and

means, responsive to the means for measuring the first predetermined time period, responsive to the means for measuring the second predetermined time period and responsive to the sensing means, for controlling the switch in such a manner that the switch is closed during a subsequent pulse of the synchronization signal occurring during the second time period and is opened thereafter.

35. A circuit as recited in claim 34, wherein the means for measuring the first time period comprises:

a second oscillator circuit;

a counter responsive to pulses of the second oscillator circuit and having an output which corresponds to the number of pulses of the second oscillator circuit; and

a first group of logic circuitry responsive to the counter so that, upon the output of the counter reaching a predetermin- ed value corresponding to the first time period, a signal will be sent to the means for controlling the switch.

36. A circuit as recited in claim 34, wherein the means for measuring the second time period comprises:

a second oscillator circuit;

a counter responsive to pulses of the second oscillator circuit and having an output which corresponds to the number of pulses of the second oscillator circuit; and

a second group of logic circuitry responsive to the counter so that, upon the output of the counter reaching a predetermined value corresponding to the end of the second time period. a signal will be sent to the means for controlling the switch.

37. A circuit recited in claim 34, wherein the means for measuring the first time period comprises:

a second oscillator circuit;

a counter responsive to pulses of the second oscillator circuit and having an output which corresponds to the number of pulses of the second oscillator circuit; and a first group of logic circuitry responsive to the counter so that, upon the output of the counted reaching a predetermined value corresponding to the first time period, a signal will be sent to the means for controlling the switch;

and wherein the means for measuring the second time period comprises:

a second group of logic circuitry responsive to the counter so that, upon the output of the counter reaching a predetermined value corresponding to the sum of the first time period and the second time period, a signal will be sent to the means for controlling the switch.

38. A circuit as recited in claim 37, further comprising:

means, responsive to the sensing means and responsive to the first group of logic circuitry, for resetting the counter upon a subsequent pulse of the synchronization signal occurring after the end of the first time period.

39. A circuit as recited in claim 34, further comprising:

means, responsive to the means for controlling the switch, for disabling operation of the static inverter if a subsequent pulse of the synchronization signal does not occur during the second time period.

40. A circuit as recited in claim 34, wherein the switch comprises:

a transistor, connected between the oscillator and the synchronization signal, having the conductance between the terminals connected to the oscillator and the synchronization signal determined by signals applied to its third terminal by the means for controlling the switch.

41. A circuit as recited in claim 34, wherein the switch comprises:

a field effect transistor having its source and drain connected between the oscillator and the synchronization signal, and having the voltage applied to its gate controlled by the means for controlling the switch.

42. A circuit as recited in claim 34, further comprising:

means for receiving pulses of the synchronization signal generated outside of the static inverter.

43. A circuit as recited in claim 34, further comprising:

means for receiving pulses of the synchronization signal generated within the static inverter.

44. A circuit as recited in claim 42, further comprising:

means for receiving pulses of the synchronization signal generated within the static inverter.

45. A circuit as recited in claim 42 or 44, further comprising:

means for preventing a DC voltage component of the synchronization signal generated outside of the static inverter from being sensed by the sensing means.

46. A circuit as recited in claim 45, wherein the means for preventing a DC voltage component from being sensed comprises:

a capacitor with a first side connected to the external synchronization signal receiving means and with its second side connected to the sensing means; and

a resistor connected on a first side to the second side of the capacitor and on a second side to ground potential.

47. A circuit as recited in claim 46, wherein the switch comprises:

a field effect transistor having the voltage applied to its gate controlled by the means for controlling the switch and connected so that pulses of the synchronization signal generated by the static inverter will pass through the body diode of the field effect transistor to the sensing means when the field effect transistor is made non-conductive by the means for controlling the switch.

48. A circuit as recited in claim 47 further comprising:

a second field effect transistor having the voltage applied to its gate also controlled by the means for controlling the switch, and having its source and drain connected between the capacitor and the sensing means in such a manner that pulses of the synchronization signal generated outside of the static inverter will pass through the body diode of the second field effect transistor when the second field effect transistor is made non-conductive by the means for controlling the switch.

49. A circuit as recited in claim 48, further comprising:

means for measuring a third predetermined time period commencing with the initial powering up of the static inverter; and

means, responsive to the means for measuring the third predetermined time period, for applying a voltage to the gate of the second field effect transistor making it non-conductive during the third predetermined time period but allowing the means for controlling the switch to make the second field effect transistor conductive after the end of the third predetermined time period.

50. A circuit as recited in claim 34, further comprising:

means, responsive to the sensing means and the means for measuring the first predetermined time period, for resetting the means for measuring the first predetermined time period upon a subsequent pulse of the synchronization signal occurring after the end of the first time period.

51. A circuit as recited in claim 35 or 37, wherein the counter has a plurality of outputs corresponding to the number of pulses of the second oscillator circuit for providing a choice of predetermined lengths of the first time period without replacement of the counter.

52. A circuit as recited in claim 36 or 37, wherein the counter has a plurality of outputs corresponding to the number of pulses of the second oscillator circuit for providing a choice of predetermined lengths of the second time period without replacement of the counter.

53. A circuit as recited in claim 51, wherein the counter has a plurality of outputs corresponding to the number of pulses of the second oscillator circuit for providing a choice of predetermined lengths of the second time period without replacement of the counter.

54. A circuit for boosting a DC voltage in a static inverter, which comprises:

means establishing a reference voltage;

a comparator having at a first input a voltage corresponding to the DC voltage and at a second input the reference voltage;

a transformer, having its secondary serve as the output of the circuit; and

a switch, responsive to the comparator, connected between the DC voltage and the primary of the transformer, so that when the comparator determines that the reference voltage is greater than the voltage corresponding to the DC voltage, the switch connects the DC voltage to the primary of the transformer, causing a voltage to be induced in the secondary of the transformer providing a boosted DC voltage at the output of the circuit.

55. A circuit for boosting a DC voltage in a static inverter, which comprises:

means establishing a reference voltage;

a comparator having at a first input a voltage corresponding to the DC voltage and at a second input the reference voltage;

a center tap transformer having the center tap of its secondary connected to the DC voltage, and having the other terminals of its secondary serving as the output of the circuit; and a switch controlled by the comparator and connected on one side to the DC voltage and at the other side to the center tap of the primary of the transformer, so that when the comparator determines that the reference voltage is greater than the voltage corresponding to the DC voltage, the switch connects the DC voltage to the center tap of the primary of the transformer, causing a voltage to be induced in the secondary of the transformer which boosts the DC voltage appearing at the output of the circuit.

56. A circuit as recited in claim 55, wherein the switch comprises:

a transistor having the conductance between its terminals connected between the DC voltage and the center tap of the primary of the transformer determined by a signal applied to its third terminal corresponding to the output of the comparator.

57. A circuit as recited in claim 55, wherein the switch comprises:

a field effect transistor having its source and drain connected between the DC voltage and the center tap of the primary of the transformer, and having a voltage applied to its gate corresponding to the output of the comparator.

58. A circuit as recited in claim 54 or 55, wherein the reference voltage is generated by a zener diode connected between the first input of the comparator and ground potential.

59. A circuit as recited in claim 58, wherein the voltage corresponding to the DC voltage is generated by a voltage divider comprising:

a first resistor connected between the DC voltage and the second input of the comparator; and

a second resistor connected between the second input of the comparator and ground potential.

60. A circuit at the output terminals of a static inverter for absorbing energy stored by a reactive load at the static inverter, which comprises:

a switch, responsive to a control signal, connected between each output terminal of the static inverter and a common node; and means for generating the control signal closing the switch at such times as the static inverter is not sourcing power, so that energy stored by the load of the static inverter can be absorbed through the switch to the common node.

61. A circuit as recited in claim 60, wherein each switch comprises:

a transistor connected between its associated output terminal and the common node, having the conductance between the terminals determined by a signal applied to its third terminal by the control signal generating means.

62. A circuit as recited in claim 60, wherein each switch comprises:

a field effect transistor having its source and drain connected between its associated output terminal and the common node, and having the voltage applied to its gate controlled by the control signal generating means.

63. A circuit as recited in claim 62, wherein the control signal generating means comprises:

a first sensing means for sensing a period of time during which the static inverter is not sourcing power; and

means, responsive to the first sensing means, for providing a voltage pulse at the gate of each field effect transistor which makes each field effect transistor conductive.

64. A circuit as recited in claim 63, further comprising:

a second sensing means for sensing the beginning of a time during which the static inverter is sourcing power; and

means, responsive to the second sensing means, for providing a voltage pulse at the gate of each field effect transistor opposite in polarity from that provided responsive to the first sensing means, which ensures that each field effect transistor is not conductive.

65. A method for generating a periodic electrical signal in a static inverter, comprising the steps of:

periodically charging a capacitor through a plurality of resistors connected in series with each other and in series with the capacitor;

periodically discharging the capacitor through the resistors; and

selectively connecting a low impedance path across one or more of the resistors during the charging and discharging of the capacitor, so that a periodic electrical signal of a predetermined shape appears at the capacitor.

66. A method as recited in claim 65, wherein the charging step comprises:

periodically connecting the series of resistors to a charging voltage.

67. A method as recited in claim 66, wherein the discharging step comprises:

periodically connecting the series of resistors to a discharging voltage.

68. A method as recited in claim 67, further comprising the steps of:

comparing the output power of the static inverter to the output power of one or more static inverters connected in parallel to the first static inverter; and

modulating the charging voltage in response to the result of the comparing step.

69. A method as recited in claim 68, further comprising the step of:

modulating the discharging voltage in response to the result of the comparing step.

70. A method of synchronizing an oscillator in a static inverter with pulses of a synchronization signal, comprising the steps of:

sensing the presence of a pulse of the synchronization signal;

measuring a first predetermined time period commencing with the pulse;

measuring a second predetermined time period commencing with the end of the first predetermined time period;

closing a switch connecting the synchronization signal to the oscillator during a subsequent pulse of the synchronization signal occurring during the second time period; and

opening the switch after the subsequent pulse of the synchronization signal occurring during the second time period.

71. A method as recited in claim 70, further comprising the step of:

disabling the static inverter if a subsequent pulse of the synchronization signal does not occur during the second predetermined time period.

72. A method as refitted in claim 70, further comprising the step of:

remeasuring the first predetermined time period upon a subsequent pulse of the synchronization signal occurring after the first predetermined time period.

73. A method for boosting a DC voltage in a static inverter, comprising the steps of:

establishing a reference voltage;

comparing the reference voltage to a voltage corresponding to the DC voltage; and closing a switch connected between the DC voltage and the primary of a transformer in response to the comparing step, so that a voltage is induced in the secondary of the transformer which boosts the DC voltage to the static inverter.

74. A method for absorbing energy stored by a reactive load of a static inverter, comprising the steps of:

sensing a period of time during which the static inverter is not sourcing power; and

closing a switch between each output terminal of the static inverter and a common node when the static inverter is not sourcing power, so that energy stored by the reactive load is absorbed through the switch to the common mode.

75. A method as recited in claim 74, wherein the switch is a field effect transistor with its source and drain connected between the output terminal and the common mode;

and wherein the step of closing the switch comprises:

providing a voltage at the gate of the field effect transistor which makes the field effect transistor conductive when the static inverter is not sourcing power.

76. A method as recited in claim 75, further comprising the steps of:

sensing the beginning of a period of time during which the static inverter is sourcing power; and providing a voltage at the gate of the field effect transistor which ensure that the field effect transistor is non-conductive when the static inverter is sourcing power.

FIG. 1

FIG. 2

120 KHz. CLOCK

CURRENT SOURCE 50

SWITCH NETWORK 54

FIG. 2A

# FIG. 3

0218414

# FIG. 4

1.25 MSEC

FIG. 5

FIG. 6

FIG. 7

FIG. 7A

FIG. 7B

FIG. 8

REGULATOR
307

FIG. 9

0218414

FIG. 9A

0218414